(19) Europäisches Patentamt
European Patent Office
Office européen des brevets

(11) **EP 4 671 774 A1**

(12) **EUROPEAN PATENT APPLICATION**

(43) Date of publication:
**31.12.2025   Bulletin 2026/01**

(21) Application number: **24185068.4**

(22) Date of filing: **27.06.2024**

(51) International Patent Classification (IPC):
**G01R 27/08** $^{(2006.01)}$

(52) Cooperative Patent Classification (CPC):
**G01R 27/08; G01R 31/52;** G01R 31/006;
G01R 31/58

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(71) Applicants:
• **Ningbo Geely Automobile Research
& Development Co. Ltd.
Hangzhou Bay New District
Ningbo 315336 (CN)**

• **Zhejiang Geely Holding Group Co., Ltd.
Hangzhou, Zhejiang 310051 (CN)**

(72) Inventors:
• **SORANI, Heza
421 51 GÖTEBORG (SE)**
• **KELES, Nevzat
417 24 GÖTEBORG (SE)**
• **BAIRU, Yared
417 15 GÖTEBORG (SE)**

(74) Representative: **Zacco Sweden AB
P.O. Box 5581
Löjtnantsgatan 21
114 85 Stockholm (SE)**

(54) **A METHOD FOR DETERMINING A RESISTANCE VALUE**

(57)     A method for determining a resistance value (R Wire_L1) of a section (S) of a power distribution wiring harness (2) connecting a DC voltage source (1) with a first electrical load (L1) and with a second electrical load (L2), wherein a supply current to the first and second electrical loads (L1, L2) is configured to be routed partly through a common electrical conductor of said power distribution wiring harness (2). The method comprises obtaining, during a first detection event in which the first electrical load is in an inactive operating state, terminal voltage level (U_VS_Inactive) of the DC voltage source (1) and voltage level (U_L1_Inactive) of the first electrical load (L1). The method also comprises obtaining, during a second detection event in which the first electrical load (L1) is in an active operating state, terminal voltage level (U_VS_Active) of the DC voltage source (1), the voltage level (U_L1_Active) of the first electrical load (L1) and an electrical current level (I_L1_Active) of the first electrical load (L1). Moreover, the method comprises calculating the resistance value (R Wire_L1) of the section (S) of the power distribution wiring harness (2) that is connecting the DC voltage source (1) with the first electrical load (L1) based on the obtained terminal voltage level (U_VS_Inactive) of the DC voltage source (1) in the inactive operating state; the voltage level (U_L1_Inactive) of the first electrical load (L1) in the inactive operating state; the terminal voltage level (U_VS_Active) of the DC voltage source (1) in the active operating state; the voltage level (U_L1_Active) of the first electrical load (L1) in the active operating state; and the electrical current level (I_L1_Active) of the first electrical load (L1) in the active operating state.

FIG.1

## Description

TECHNICAL FIELD

The present disclosure relates to a method for determining a resistance value of a section of a power distribution wiring harness. The disclosure further relates to an corresponding electrical system for a vehicle.

The method and system and particularly suitable for being implemented in connection with vehicle electrical power supply circuits, such as combustion engine powered vehicles, hybrid electric vehicles, hydrogen powered vehicles and electrically powered vehicles.

Moreover, even if the method and system according to the disclosure will be described primarily in relation to a car, the method and system are not restricted to this particular vehicle, but may as well be installed or implemented in another type of vehicle, such as a truck, a bus, a rail vehicle, a flying vehicle, a marine vessel, an off-road vehicle, a mining vehicle, an agriculture vehicle, a working vehicle such as a wheel loader or excavator, a forest vehicle such as harvesters or forwarders, a motorcycle or the like.

BACKGROUND

In all electrical and conventional vehicles, various low-voltage electrical components, such as electrical control units (ECU's) and safety critical electrical components, require a reliable, stable and sufficiently high DC voltage level for being able to operate reliably. Consequently, the DC power supply system is designed based on the system current and voltage requirements that is necessary for desired operational performance of the electrical system and electrical components. Insufficient power supply may quickly result in reduced voltage and current supply levels that may have negative impacts on the safe and reliable functioning of the safety critical electrical components.

Since the automotive industry and almost all OEM's are moving towards increasing electrification of vehicles this will increase the number of electrical components in each vehicle. More and more, safety critical, functions are relied and moved on electricity dependency from mechanical e.g., steering, braking and self-driving systems this is increasing the performances and safety/ASIL classifications on the electrical system.

Consequently, in the field of vehicle electrical power supply, there is an increasing demand for improving the robustness and operation of the electrical components.

SUMMARY

An object of the present disclosure is to provide a method and system for determining a resistance value where the previously mentioned problems are avoided. This object is at least partly achieved by the features of the independent claims. The dependent claims contain further developments thereof.

According to a first aspect of the present disclosure, there is provided a method for determining a resistance value of a section of a power distribution wiring harness connecting a DC voltage source with a first electrical load and with a second electrical load, wherein a supply current to the first and second electrical loads is configured to be routed partly through a common electrical conductor of said power distribution wiring harness, the method comprising: obtaining, during a first detection event in which the first electrical load is in an inactive operating state, terminal voltage level of the DC voltage source and voltage level of the first electrical load; obtaining, during a second detection event in which the first electrical load is in an active operating state, terminal voltage level of the DC voltage source, the voltage level of the first electrical load and an electrical current level of the first electrical load; and calculating the resistance value of the section of the power distribution wiring harness that is connecting the DC voltage source with the first electrical load based on the obtained: terminal voltage level of the DC voltage source in the inactive operating state; voltage level of the first electrical load in the inactive operating state; terminal voltage level of the DC voltage source in the active operating state; voltage level of the first electrical load in the active operating state; and electrical current level of the first electrical load in the active operating state.

According to a second aspect of the present disclosure, there is provided an electrical system for a vehicle comprising: a DC voltage source; a first electrical load; a second electrical load; a power distribution wiring harness connecting the DC voltage source with the first electrical load and with the second electrical load, wherein the power distribution wiring harness is configured to route a supply current from the DC voltage source to the first and second electrical loads through a common electrical conductor of said power distribution wiring harness; and an electronic control system configured for determining a resistance value of a section of the power distribution wiring harness, wherein the electronic control system is configured for: obtaining, during a first detection event in which the first electrical load is in an inactive operating state, terminal voltage level of the DC voltage source and voltage level of the first electrical load; obtaining, during a second detection event in which the first electrical load is in an active operating state, terminal voltage level of the DC voltage source, the voltage level of the first electrical load and an electrical current level of the first electrical load; and calculating the resistance value of the section of the power distribution wiring harness that is connecting the DC voltage source with the first electrical load based on the obtained: terminal voltage level of the DC voltage source in the inactive operating state; voltage level of the first electrical load in the inactive operating state; terminal voltage level of the DC voltage source in the active operating state; voltage level of the first electrical load in the active operating state; and electrical current level of the first electrical load in the active operating state.

In this way, it becomes possible swiftly, easily and accurately determine the resistance value of an internal resistance of a section of a power distribution wiring harness, even without needing to shut-down the vehicle for obtaining the resistance value, and also without need for providing the power distribution electrical circuit with a dedicated resistance measuring circuit. Moreover, as a result of the swift and easy determination of the resistance value, the resistance value of the wiring harness can be monitored over time and enable the system to take appropriate actions well-before starting to see any vehicle operation problems resulting from increased resistance due to aging or the like.

Further advantages are achieved by implementing one or several of the features of the dependent claims.

In some example embodiments, that may be combined with any one or more of the above-described embodiments, the resistance value of the section of the power distribution wiring harness that is connecting the DC voltage source with the first electrical load is calculated based on the following equation:

$$R_{Wire\_L1} = \frac{(U_{L1\_Inactive} - U_{L1\_Active}) - (U_{VS\_Inactive} - U_{VS\_Active})}{I_{L1\_Active}}.$$

In this equation, the term $R_{Wire\_L1}$ is the resistance value of the section of the power distribution wiring harness, $U_{L1\_Inactive}$ is the voltage level of the first electrical load in the inactive operating state, $U_{L1\_Active}$ is the voltage level of the first electrical load in the active operating state, $U_{VS\_Inactive}$ is the terminal voltage level of the DC voltage source in the inactive operating state, $U_{VS\_Active}$ is the terminal voltage level of the DC voltage source in the active operating state, and $I_{L1\_Active}$ is the electrical current level of the first electrical load (L1) in the active operating state.

In some example embodiments, that may be combined with any one or more of the above-described embodiments, a branch-off point of the first electrical load is located upstream of the second electrical load as seen along the length of the power distribution wiring harness.

In some example embodiments, that may be combined with any one or more of the above-described embodiments, a branch-off point of the second electrical load is located upstream of the first electrical load as seen along the length of the power distribution wiring harness.

In some example embodiments, that may be combined with any one or more of the above-described embodiments, the common electrical conductor of said power distribution wiring harness that routes the supply current to both the first and second electrical loads extends from a region close or at a positive terminal of the voltage source to a branch-off point of the first or second electrical load.

In some example embodiments, that may be combined with any one or more of the above-described embodiments, an individual current consumption of the second electrical load, and any other electrical load that is/are connected to the DC voltage source via the power distribution wiring harness, is substantially identical during the first and second detection events. Thereby, the resistance value calculation provides a more accurate result of the actual internal resistance of the wiring harness.

In some example embodiments, that may be combined with any one or more of the above-described embodiments, the power distribution wiring harness is free from being connected to a dedicated resistance measuring control system. Thereby, a more cost-efficient electrical system is provided.

In some example embodiments, that may be combined with any one or more of the above-described embodiments, the method further comprises obtaining, during each of the first and second detection events, electrical current level of the second electrical load, and any other electrical load that is/are connected to the DC voltage source via the power distribution wiring harness. Thereby, it can be verified that the current level of one or more other load are indeed the same during the first and second detection events, respectively, such that a more accurate determination of the resistance value of obtained.

In some example embodiments, that may be combined with any one or more of the above-described embodiments, the method further comprises the step of setting a switch associated with the first load in an open state during the first detection event. Thereby, the current through the first load is certainly zero during the first detection event, i.e. inactive operating state.

In some example embodiments, that may be combined with any one or more of the above-described embodiments, a current consumption of the first electrical load is substantially zero during the first detection event.

In some example embodiments, that may be combined with any one or more of the above-described embodiments, the first and second detection events are performed consecutively within a short time span. Thereby, the likelihood that the current level of one or more of the other loads connected to the wiring harness are indeed the same during the first and second detection events, respectively, is increased, because there is less time for making adjustments of the operating status of said other loads.

In some example embodiments, that may be combined with any one or more of the above-described embodiments, the first detection event is performed before the second detection event, or the second detection event is performed before the first detection event.

In some example embodiments, that may be combined with any one or more of the above-described embodiments, each of the first and second detection events are performed within a short time interval. Thereby, the likelihood that the current level of one or more of the other loads connected to the wiring harness are indeed the same during the first and second detection events, respectively, is increased, because there is less time for making adjustments of the operating status of said other loads.

In some example embodiments, that may be combined with any one or more of the above-described embodiments, the terminal voltage level of the DC voltage source is detected by a voltage sensor connected over the DC voltage source, or by a battery management system associated with the DC voltage source. Using the already available BMS for obtaining the terminal voltage level of the DC voltage source is cost-efficient because no additional voltage measurement sensor is required for detecting the terminal voltage level of the DC voltage source.

In some example embodiments, that may be combined with any one or more of the above-described embodiments, the voltage level of the first electrical load is detected by a voltage sensor connected over the first electrical load or by a voltage sensor integrated in the first electrical load. Using an already available voltage sensor integrated in the first load for obtaining the voltage level of the first load is cost-efficient because no additional voltage measurement sensor is required for detecting said voltage level.

In some example embodiments, that may be combined with any one or more of the above-described embodiments, the electrical current level of the first electrical load is detected by a current sensor provided in the power supply wire of the first electrical load or by a current sensor integrated in the first electrical load. Using an already available current level sensor integrated in the first load for obtaining the current level of the first load is cost-efficient because no additional current measurement sensor is required for detecting said current level.

In some example embodiments, that may be combined with any one or more of the above-described embodiments, the inactive operating state of the first electrical load corresponds to a disconnected operating state, or a connected but temporarily non-used or non-activated or passive operating state.

In some example embodiments, that may be combined with any one or more of the above-described embodiments, the DC voltage source is a low-voltage source, in particular with a terminal voltage level of about 12-15V, specifically about 12-50V.

In some example embodiments, that may be combined with any one or more of the above-described embodiments, the DC voltage source is a battery and/or a supercapacitor arrangement.

In some example embodiments, that may be combined with any one or more of the above-described embodiments, the method is suitable for determining a resistance value of a section of a vehicle power distribution wiring harness that is connecting a vehicle DC voltage source with a first vehicle electrical load and with a second vehicle electrical load.

In some example embodiments, that may be combined with any one or more of the above-described embodiments, the method further comprises a step of setting or ensuring that the first electrical load is set in the inactive operating state.

In some example embodiments, that may be combined with any one or more of the above-described embodiments, the method further comprises a step of setting or ensuring that the first electrical load is set in the active operating state.

In some example embodiments, that may be combined with any one or more of the above-described embodiments, the method further comprises comparing the calculated resistance value of the section of the power distribution wiring, or a voltage drop based on said resistance value, with a threshold value; and activating a vehicle load reducing control strategy and/or informing a vehicle user and/or a remote vehicle service manager about power supply concern in response to determining that the calculated resistance value of the section of the power distribution wiring, or the voltage drop based on said resistance value, is larger than the threshold value.

Consequently, in some example embodiments, that may be combined with any one or more of the above-described embodiments, the present disclosure relates to a method for monitoring the vehicle electrical system, wherein the method comprises the steps of: recurringly during the vehicle life time, obtaining a resistance value $R_{Wire\_L1}$ of a section S of the power distribution wiring harness of the vehicle as described above; comparing the obtained resistance value of the section of the power distribution wiring, or an associated voltage drop based on said resistance value, with a predetermined or adaptive threshold value; and activating a vehicle load reducing control strategy and/or informing a vehicle user and/or a remote vehicle service manager about power supply concern in response to determining that the calculated resistance value of the section of the power distribution wiring, or the voltage drop based on said resistance value, is larger than said the threshold value. Thereby, appropriate counter-actions can be decided and implemented well in advance of actual problems occurring.

In some example embodiments of the electrical system described above, that may be combined with any one or more of the above-described embodiments, the resistance value of the section of the power distribution wiring harness that is connecting the DC voltage source with the first electrical load is calculated based on the following equation:

$$R_{Wire\_L1} = \frac{(U_{L1\_Inactive} - U_{L1\_Active}) - (U_{VS\_Inactive} - U_{VS\_Active})}{I_{L1\_Active}}.$$

In this equation, the term $R_{Wire\_L1}$ is the resistance value of the section of the power distribution wiring harness, $U_{L1\_Inactive}$ is the voltage level of the first electrical load in the inactive operating state, $U_{L1\_Active}$ is the voltage level of the first electrical load in the active operating state, $U_{VS\_Inactive}$ is the terminal voltage level of the DC voltage source in the inactive operating state, $U_{VS\_Active}$ is the terminal voltage level of the DC voltage source in the active operating state, and $I_{L1\_Active}$ is the electrical current level of the first electrical load (L1) in the active operating state.

In some example embodiments of the electrical system, that may be combined with any one or more of the above-described embodiments, the power distribution wiring harness comprises a branch-off point located at the first electrical load and upstream of the second electrical load as seen along the length of the power distribution wiring harness.

In some example embodiments of the electrical system, that may be combined with any one or more of the above-described embodiments, the power distribution wiring harness comprises a branch-off point located at the second electrical load and upstream of the first electrical load as seen along the length of the power distribution wiring harness.

In some example embodiments of the electrical system, that may be combined with any one or more of the above-described embodiments, the common electrical conductor of said power distribution wiring harness that is configured to route supply current to both the first and second electrical loads extends from a region close or at a positive terminal of the voltage source to a branch-off point of the first or second electrical load.

In some example embodiments of the electrical system, that may be combined with any one or more of the above-described embodiments, the electronic control system is configured for controlling operation of the first a second loads, and any other electrical loads that is/are connected to the DC voltage source via the power distribution wiring harness, such that an individual current consumption of the second electrical load, and any other electrical load that is/are connected to the DC voltage source via the power distribution wiring harness, is substantially identical during the first and second detection events.

In some example embodiments of the electrical system, that may be combined with any one or more of the above-described embodiments, the electrical system is free from a dedicated resistance measuring control system connected to the power distribution wiring harness.

In some example embodiments of the electrical system, that may be combined with any one or more of the above-described embodiments, the electronic control system further is configured for obtaining, during each of the first and second detection events, electrical current level of the second electrical load, and any other electrical load that is/are connected to the DC voltage source via the power distribution wiring harness.

In some example embodiments of the electrical system, that may be combined with any one or more of the above-described embodiments, the electrical system further comprises a switch associated with the first load, wherein the electronic control system is configured to set the switch in an open state during the first detection event.

In some example embodiments of the electrical system, that may be combined with any one or more of the above-described embodiments, the electronic control system is configured to control the electric system, such that a current consumption of the first electrical load is substantially zero during the first detection event.

In some example embodiments of the electrical system, that may be combined with any one or more of the above-described embodiments, the electronic control system is configured to control the electrical system, such that the first and second detection events are performed consecutively within a short time span.

In some example embodiments of the electrical system, that may be combined with any one or more of the above-described embodiments, the electronic control system is configured to control the electrical system, such that each of the first and second detection events is performed within a short time interval.

In some example embodiments of the electrical system, that may be combined with any one or more of the above-described embodiments, the electrical system further comprises a voltage sensor connected over the DC voltage source and configured to detect the terminal voltage level of the DC voltage source; or a battery management system associated with the DC voltage source and configured to detect the terminal voltage level of the DC voltage source.

In some example embodiments of the electrical system, that may be combined with any one or more of the above-described embodiments, the electrical system further comprises a voltage sensor connected over the first electrical load or a voltage sensor integrated in the first electrical load, wherein the voltage sensor is configured to detect the voltage level of the first electrical load.

In some example embodiments of the electrical system, that may be combined with any one or more of the above-described embodiments, the electrical system further comprises a current sensor provided in the power supply wire of the first electrical load; or a current sensor integrated in the first electrical load, wherein the current sensor is configured to detect the electrical current level of the first electrical load.

In some example embodiments of the electrical system, that may be combined with any one or more of the above-described embodiments, the inactive operating state of the first electrical load corresponds to a disconnected operating state, or a connected but temporarily non-used or non-activated or passive operating state.

In some example embodiments of the electrical system, that may be combined with any one or more of the above-described embodiments, the DC voltage source is a low-voltage source, in particular with a terminal voltage level of about 12-15V, specifically about 12-50V.

In some example embodiments of the electrical system, that may be combined with any one or more of the above-described embodiments, the DC voltage source is a battery and/or a supercapacitor arrangement.

In some example embodiments of the electrical system, that may be combined with any one or more of the above-described embodiments, the electronic control system further is configured for setting or ensuring that the first electrical load is in the inactive operating state.

In some example embodiments of the electrical system, that may be combined with any one or more of the above-described embodiments, the electronic control system further is configured for setting or ensuring that the first electrical load is in the active operating state.

In some example embodiments of the electrical system, that may be combined with any one or more of the above-described embodiments, at least one of the first and second electrical load is an electronic controller.

In some example embodiments of the electrical system, that may be combined with any one or more of the above-described embodiments, the electronic control system is configured for: comparing the calculated resistance value of the section of the power distribution wiring, or a voltage drop based on said resistance value, with a threshold value; and activating a vehicle load reducing control strategy and/or informing a vehicle user and/or a remote vehicle service manager about a power supply concern in response to determining that the calculated resistance value of the section of the power distribution wiring, or the voltage drop based on said resistance value, is larger than the threshold value.

The present disclosure also relates to an electrical system that is configured for: recurringly in a periodic manner during the vehicle life time, obtaining a resistance value $R_{Wire\_L1}$ of a section S of the power distribution wiring harness of the vehicle as described above; comparing the obtained resistance value of the section of the power distribution wiring, or a voltage drop based on said resistance value, with a threshold value; and activating a vehicle load reducing control strategy and/or informing a vehicle user and/or a remote vehicle service manager about power supply concern in response to determining that the calculated resistance value of the section of the power distribution wiring, or the voltage drop based on said resistance value, is larger than the threshold value. Thereby, appropriate counter-actions can be decided and implemented well in advance of actual problems occurring.

The disclosure also concerns a vehicle comprising the electrical system as described above.

Further features and advantages of the invention will become apparent when studying the appended claims and the following description. The skilled person in the art realizes that different features of the present disclosure may be combined to create embodiments other than those explicitly described hereinabove and below, without departing from the scope of the present disclosure.

BRIEF DESCRIPTION OF DRAWINGS

The method and system for determining a resistance value according to the disclosure will be described in detail in the following, with reference to the attached drawings, in which

Fig. 1            shows schematically an example layout of an electrical power supply circuit including a power distribution wiring harness,

Fig. 2            shows schematically a further example layout of said electrical power supply circuit,

Fig. 3            shows schematically an electrical circuit of a battery electric vehicle,

Fig. 4            shows schematically a side-view of a vehicle having the electrical circuit similar to that described with reference to figure 3,

Fig. 5            shows schematically an example layout of a power supply circuit of a vehicle,

Fig. 6A-6B      show schematically a first example layout of a power supply circuit of a vehicle in inactive and active state of the first load, respectively

Fig. 7A-7B      show schematically a second example layout of a power supply circuit of a vehicle in inactive and active state of the first load, respectively,

Fig. 8A-8B      show schematically a third example layout of a power supply circuit of a vehicle in inactive and active state of the first load, respectively,

Fig. 9A-9B      show schematically a fourth example layout of a power supply circuit of a vehicle in inactive and active state of the first load, respectively,

Fig. 10A-10B    show schematically a fifth example layout of a power supply circuit of a vehicle in inactive and active state of the first load, respectively,

Fig. 11A-11    B show schematically a sixth example layout of a power supply circuit of a vehicle in inactive and active state of the first load, respectively.

DESCRIPTION OF EXAMPLE EMBODIMENTS

Various aspects of the disclosure will hereinafter be described in conjunction with the appended drawings to illustrate and not to limit the disclosure, wherein like designations denote like elements, and variations of the described aspects are not restricted to the specifically shown embodiments, but are applicable on other variations of the disclosure.

The present disclosure relates to an electrical system for a vehicle, in particular a low-voltage power supply system for a vehicle.

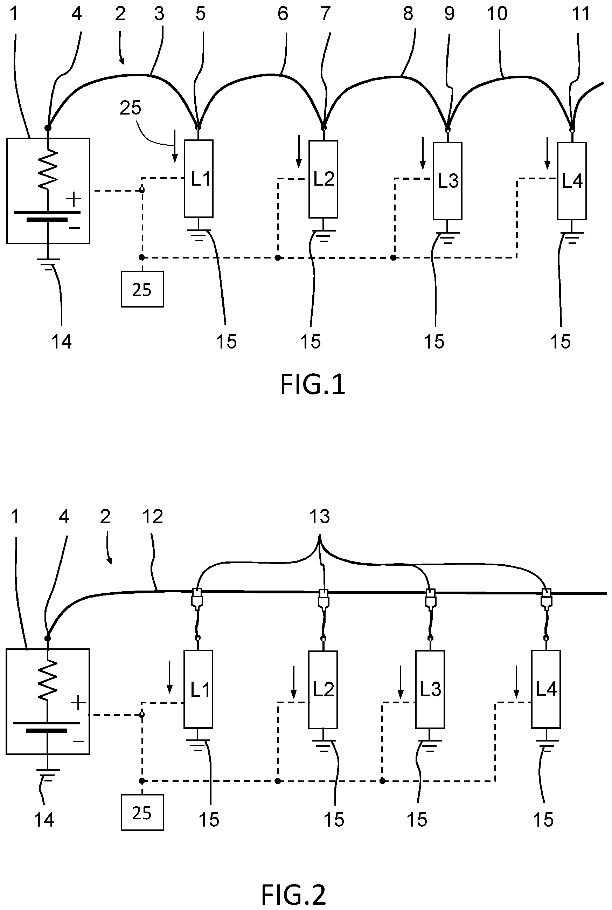

Figure 1 schematically shows an example embodiment of a low-voltage power supply system for a vehicle having a DC voltage source 1, a plurality of electrical loads L1-L4 and a power distribution wiring harness 2 connecting the DC voltage source 1 with the plurality of electrical loads L1-L4 for supplying electrical power to said of electrical loads L1-L4.

The power distribution wiring harness 2 is configured to route a supply current from one or more DC voltage sources 1 to the plurality of electrical loads L1-L4 through a common electrical conductor or wire of said power distribution wiring harness 2, for avoiding the need to install and use an individual electrical power supply line for connecting each individual electrical load L1-L4 with the DC voltage source 1.

The power distribution wiring harness 2 may be designed in various ways depending on the number and type of electrical loads, their physical location in the vehicle relative to the voltage source 1, and the desire to keep the amount of wiring to a minimum, etc. In the schematic example embodiment of figure 1, the power distribution wiring harness 2 comprises four individual interconnected wire sections, wherein a first wire section 3 is connecting a positive terminal 4 of the DC voltage source 1 with a positive terminal 5 of a first electrical load L1. Furthermore, a second wire section 6 is connecting the positive terminal 5 of the first electrical load L1 with a positive terminal 7 of a second electrical load L2, a third wire section 8 is connecting the positive terminal 7 of the second electrical load L2 with a positive terminal 9 of a third electrical load L3, and a fourth wire section 10 is connecting the positive terminal 9 of the third electrical load L3 with a positive terminal 11 of a fourth electrical load L4.

An electronic control system 25 may be operatively connected to a battery management system (BMS) of the voltage source 1, or the like, and to one or more the electrical loads L1-L4 for detecting relevant parameters of the voltage source 1 and the to one or more electrical loads L1-L4, and possibly also for controlling operation of the voltage source 1 and/or at least electrical load L1-L4.

The electronic control system 25 may be a centralised electronic control system, i.e. composed mainly of one main electronic controller having direct contact with actuators, sensors, electrical loads, etc., or a more distributed electronic control system, i.e. composed of a distributed network of smaller electronic control units having different tasks and being interconnected by a data communication network.

The electrical loads L1-L4 are for example safety-critical electrical equipment such as one or more electronic controllers (ECU's) for vehicle self-driving capability, electrically powered steering unit and electrically powered, etc. The electrical loads L1-L4 may also be more comfort oriented electrical equipment, such as electrically powered air conditioning unit, electrical seat adjustment motors, electrical window opening unit, etc. The electronic control system 25 of figure 1 may also be connected and powered via the power distribution wiring harness 2, at least partly in case of a distributed electronic control system.

According to an alternative solution, as schematically illustrated in figure 2, the power distribution wiring harness 2 comprises a main electrical conductor 12 connected to the positive terminal 4 of the DC voltage source 1, wherein the individual electrical loads L1-L4 are electrically connected to the main electrical conductor 12 at suitable locations via appropriate electrical connectors 13.

For example, the individual electrical loads L1-L4 can be electrically connected to the main electrical conductor 12 via self-stripping electrical T-Tap wire connectors 13 or the like that are configured to tap into the existing main electrical conductor at any position, i.e. at any mid-span position, without requiring pre-cutting or pre-stripping of the main electrical conductor 12.

In both examples, the negative terminal 14 of the DC voltage source 1 is connected to a ground connection 14 of the vehicle metal chassis, and each of the negative terminals of the electrical loads L1-L4 are also connected to ground connections 15 of the vehicle metal chassis for providing a closed electrical circuit for each electrical load and for enabling an electric current to flow through each electrical load. However, the negative terminal 14 of the DC voltage source 1 may alternatively be electrically connected to the negative terminals of the electrical loads L1-L4 by means of a dedicated negative power distribution wiring harness having a similar design as the positive negative power distribution wiring harness 2 described above with reference to fig. 1 and 2.

The electrical system and/or the power distribution wiring harness of the present disclosure may be installed in a conventional combustion engine powered vehicle, a hybrid-electric powered vehicle or a pure electrical powered vehicle, such as a battery electric vehicle.

The electrical power distribution system of a vehicle having merely a low-voltage voltage source, such as for example a 12V, 24V or 48V electrical architecture, may have a layout similar to that of figure 1 or figure 2.

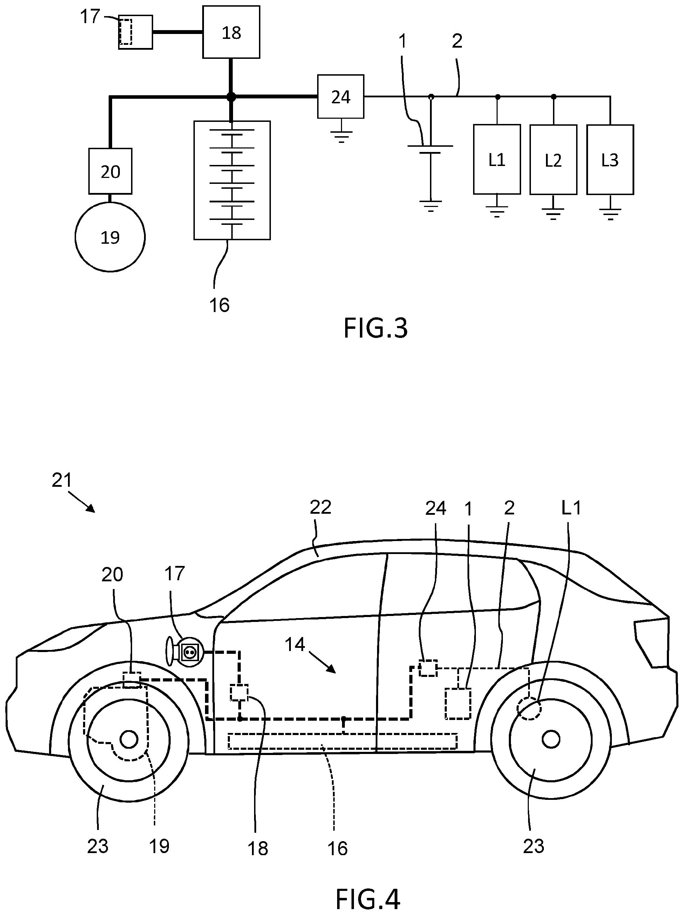

Figures 3 and 4 schematically shows an example embodiment of an electrical power distribution system of a pure electrically powered vehicle 21 having a vehicle chassis 22 and wheels 23. Such an electrical power distribution system has a high-voltage voltage source 16, in particular a high-voltage battery, having a nominal voltage level for example in the range of 200 - 1000V. The high-voltage voltage source 16 can be charged by connection to a stationary charging station via a plug-in connector 17 and an on-board charging converter 18. The drive line comprises an electrical propulsion motor 19 that is powered by electrical energy from the high-voltage voltage source 16 via a power converter 20, such as an inverter or the like. A low-voltage voltage source 1 may be connected to the high-voltage voltage source 16 via a DC/DC converter 24, and one or more low-voltage electrical loads L1-L3 may be connected to and powered by the low-voltage voltage source 1 via a power distribution wiring harness 2.

In figure 4, the electrical load L1 may be an electrically operated vehicle rear wheel braking unit.

In the following example embodiments, the method and system for determining the resistance value of a section of a power distribution wiring harness is described in connection to a DC low-voltage system, but the method and system is not limited to a low-voltage system, but may also be applied and for determining resistance value of a section of a high-voltage power distribution wiring harness.

Electrical power supply systems are often designed and dimensioned by determining the maximal electrical load that may occur in the electrical system while driving, and selecting an appropriate voltage source that has sufficient capacity to reliably provide the required electrical power. In other words, the electrical system is designed with sufficient capacity of the power supply DC/DC converter 24 and/or voltage source 1 to always deliver and provide robust voltage level to the electrical loads, because the electrical loads L1-L4 may malfunction in case of undervoltage power supply.

But there is a parameter between the electrical loads L1-L4 and voltage source 1 that is often overlooked, or at best assigned with a constant pre-determined resistance value, namely the voltage distribution wiring harness and its resistance/impedances.

The resistance/impedance of the voltage distribution wiring harness will cause a voltage drop, and the resistance level will typically increase over time due to aging. Consequently, unless the resistance level of the voltage distribution wiring harness is properly monitored over time, the increased resistance level due to aging may cause voltage drops over the power distribution wiring harness that have negative impact on voltage supply levels to the electrical loads L1-L4, in particular safety critical electrical loads.

On other words, large and unplanned voltage drops over the voltage distribution wiring harness causes reduced voltage drop over the electrical loads L1-L4, many of which may be sensitive to being underpowered, such as electronic control units and other safety-critical loads. Hence, large and unplanned voltage drops over the voltage distribution wiring harness has the potential to cause severe problems for the operational reliability of the vehicle.

There are different methods available to measure the resistances of a voltage distribution wiring harness. It is for example possible to provide the vehicle electrical system with a dedicated resistance measuring control system that is connected to the power distribution wiring harness and configured for routing a dedicated resistance measuring current through one or more sections of a power distribution wiring harness for determining the resistance of said one or more sections. However, such dedicated resistance measuring control system is typically operated when the power distribution wiring harness is in a non-use operating state, and requires additional electrical wires for connecting a measurement power source to the power distribution wiring harness, and electrical switches for isolating said sections of the power distribution wiring harness during the resistance measurement.

Moreover, the dedicated resistance measuring control system may require a separate dedicated measuring voltage source for providing the necessary stable current and voltage required for performing a resistance measurement, while the main power supply, e.g. 12V battery, is temporarily disconnect to ensure the correct voltage drop over the desired cable resistance is determined.

An alternative approach is to calculate the resistances of the voltage distribution wiring harness based on estimated voltage drop over the voltage distribution wiring harness in combination with measurement of the current flowing through the voltage distribution wiring harness. Unfortunately, there are generally many electrical loads placed at different areas of the vehicle and the power source(s) can be varied between DC/DC converter, battery, alternator, Super Capacitor, etc. In other words, it is generally difficult to correctly assess the current flow in a large and complex electrical network. Moreover, it is also difficult to correctly assess the true internal resistance of the power source(s) and electrical loads that may be activated simultaneously. Consequently, such resistance measurement typically involve high risk due to unintended use of wrong parameters and values. Basically, correct interpretation of the electrical system parameters is important for avoiding the risk of estimating the wrong impedance value of the power distribution wiring harness.

In the present case, the inductance value, $X_L = L*di/dt$, of the power distribution wiring harness can be assumed to zero. Hence, method and system of the present disclosure can focus on determining the resistance value of the power distribution wiring harness.

The present disclosure provides a solution to obtain the resistance value of the power distribution wiring harness with high accuracy, also in large electrical systems with multiple electrical loads, and also enabling execution of the method/system while the electrical loads are activated and consumes electrical power, thereby avoiding the need to shut-down the electrical system for performing the resistance measurement of the power distribution wiring harness.

The solution according to the present disclosure involves obtaining values of certain parameters in an electrical system with one or more electrical loads. Most of the electrical loads of the electrical system can remain activated or in an operational state during the resistance value detection process.

The solution according to the present disclosure also involves calculating a resistance of a section of the power distribution wiring harness by applying a mathematical equation and using said measured values of said parameters of the electrical system as input variables. The solution according to the present disclosure does thus not require any deep knowledge of the electrical layout of the electrical system or power distribution wiring harness, which enables a more simple and straightforward application of the method. Moreover, the solution does also not require an advanced dedicated resistance measuring system that add cost, complexity and weight to the vehicle.

The resistance measuring method and system requires measurement data of voltage and current at selected positions of the electrical circuit. Each voltage and current measurement may be based on a single measurement sample, or an averaged value of a plurality of measurements taken over a time period, or a minimum value of a plurality of voltage measurements taken over a time period and a maximum value of a plurality of current measurement taken over a time period. The time period may for be a time span of 0.1 seconds, or 1 second, or the like.

The present solution for measuring resistance of a section of the power distribution wiring harness avoids the need to measure all current and voltage at different circuit locations. Instead, present solution for requires only terminal voltage measurement of the voltage source, such as for example a battery pack, as well as the voltage and current of the first electrical load L1.

Terminal voltage measurement of the voltage source can for example be provided by Battery Management System (BMS) of the battery pack, thereby avoiding the need for an additional voltage sensor for detecting terminal voltage of voltage source.

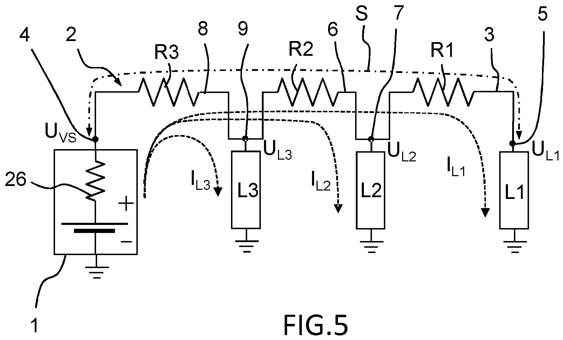

Figure 5 shows a schematic layout of an example electrical circuit having a voltage source 1, such as for example a battery, three electrical loads L1-L3 connected to the voltage source 1 via a power distribution wiring harness 2, similar to that circuit described with reference to figures 1 and 2. The voltage source 1 may have a terminal voltage level Uvs, i.e. the voltage level that can be measured between the positive and negative terminals of the voltage source 1.

Specifically, the terminal voltage level of the DC voltage source 1 may be detected by a voltage sensor connected over the DC voltage source, or by a voltage sensor integrated in the battery management system BMS associated with the DC voltage source.

The voltage level or voltage drop over the first electrical load L1 may for example be detected by a voltage sensor connected over the first electrical load or by a voltage sensor integrated in the first electrical load L1.

Similarly, the electrical current level of the first electrical load L1 may be detected by a current sensor provided in the power supply wire of the first electrical load or by a current sensor integrated in the first electrical load L1.

The DC voltage source 1 is for example a low-voltage source, in particular with a terminal voltage level of about 12-15V, specifically about 12-50V.

The DC voltage source 1 is for example a battery and/or a supercapacitor arrangement.

The terminal voltage Uvs of a voltage source, such as a battery or a capacitor may be equal to electromotive force (emf) minus the voltage drop $U_{IR}$ over the internal resistance 26 of the voltage source, i.e. Uvs = emf - $U_{IR}$. In other words, the electromotive force (emf) is equal to the terminal voltage Uvs when no current is flowing through the internal resistance 26.

The voltage over the first load L1 may be referred to as $U_{L1}$, the voltage over the second load L2 may be referred to as $U_{L2}$, and the voltage over the third load L3 may be referred to as $U_{L3}$.

The current flowing through the first load L1 may be denoted $I_{L1}$, the current flowing through the second load L2 may be denoted $I_{L2}$, and the current flowing through the third load L3 may be denoted $I_{L3}$.

In the schematic illustration of the electrical circuit of figure 5, the power distribution wiring harness 2 comprises three individual interconnected wire sections 3, 6, 8, wherein the third wire section 8 connects the positive terminal 4 of the DC voltage source 1 with the positive terminal 9 of a third electrical load L3, the second wire section 6 is connecting the positive terminal 9 of the third electrical load L3 with the positive terminal 7 of a second electrical load L2, and the first wire section 3 connects the positive terminal 7 of the second electrical load L2 with the positive terminal 5 of a first electrical load L1.

The first section 3 of power distribution wiring harness 2 has internal resistance denoted R1, the second section 6 of power distribution wiring harness 2 has internal resistance denoted R2, and the third section 8 of power distribution wiring harness 2 has internal resistance denoted R3.

If the system for example is instructed to determine the resistance value $R_{Wire\_L1}$ of a section S of the power distribution wiring harness that is connecting the DC voltage source 1 with a first electrical load L1, as schematically illustrated by a dash-dotted line in figure 5, i.e. $R_{Wire\_L1}$ = R1+R2+R3, the system would first obtain certain parameters of the electric circuit both: when the first electrical load L1 is powered by the DC voltage source, e.g. when the first electrical load L1 is an active mode or powered mode; and when the first electrical load L1 is unpowered, e.g. when the first electrical load L1 is in an inactive state, a sleep state or simply electrically disconnected from the DC voltage source, or the like, as long the current through the first load L1 is zero or at least substantially zero.

The first load may for example be set in inactive state by setting an electrical switch associated with the first load, i.e. arranged in series with the first load L1, in open state. The first load L1 may include an integrated on/off switch or the like, or an electrical on/off switch may be provided in the distribution net at a position close to the first load for controlling the current flow through the first load.

The inactive operating state of the first electrical load L1 may for example correspond to a disconnected operating state of the first load L1, i.e. being disconnected from the power supply wiring harness. Alternatively, the inactive operating state of the first electrical load L1 may for example correspond to remaining connected to the power supply wiring harness but being temporarily set in a non-used or non-activated or passive operating state.

An inactive or disconnected operating state does not necessarily mean that the first load L1 is completely disconnected or non-powered operating state. An inactive state may correspond to a low power operating state, and active state may correspond to a normal/high power operating state.

If for example the first load is an electrical vehicle braking system, an inactive state may correspond to an operating state in which the brakes are not applied, i.e. no vehicle braking action by friction brakes, and active operating state may correspond to an operating state in which the brakes are applied, i.e. vehicle braking action applied by friction brakes.

Consequently, a current consumption of the first electrical load may be substantially zero during the first detection event.

It does not matter in what order these measurements are performed and claim 1 is not restricted to the order of the steps of obtaining said parameters provided in claim 1.

The system would thus obtain, for example during a first detection event in which the first electrical load L1 is in an inactive operating state, a terminal voltage level Uvs of the DC voltage source 1 and a voltage level $U_{L1\_Inactive}$ of the first electrical load L1.

The system would also obtain, for example during a second detection event in which the first electrical load L1 is in an active operating state, a terminal voltage level Uvs of the DC voltage source 1, the voltage level $U_{L1\_Active}$ of the first electrical load L1, and an electrical current level $I_{L1\_Active}$ of the first electrical load L1.

As mentioned above, the second detection event may be provided after or before the first detection event in time.

However, the first and second detection events are preferably performed within a limited time period, such as for example within 60 seconds, specifically within 5 seconds, for increasing the likelihood that the current flow levels of the other loads L2, L3 are substantially the same during the first and second detection events.

The first and second detection events are performed consecutively, i.e. one after the other, preferably within a short time span, such as within 1 second, 5 seconds, 30 seconds, 1 minute, 5 minutes, etc. Each of the first and second detection events is performed within a short time interval, such as for example within 500 milliseconds, 1 second, 5 seconds, 30 seconds, 1 minute.

The electronic control system 25 may in some example embodiments be configured to verify that the current flow levels of the other loads L2, L3 are substantially the same during the first and second detection events.

It does not matter whether the second and third electrical loads L2, L3 are active or inactive during the resistance measurement process, as long as their power consumption is the same during both the first and second detection events.

The system is then be arranged to calculate the resistance value $R_{Wire\_L1}$ of the section S of the power distribution wiring harness based on the obtained values of said parameters.

The resistance calculation may for example be based on equation: $R_{Wire\_L1} = \dfrac{\Delta U_{L1} - \Delta U_{VS}}{I_{L1\_Active}}$.

$\Delta U_{L1} = U_{L1\_Inactive} - U_{L1\_Active}$, wherein $U_{L1\_Inactive}$ is the voltage over the first load L1 when $I_{L1} = 0A$, e.g. when the first load L1 is inactive, in sleep mode, disconnected or non-powered, and $U_{L1\_Active}$ is the voltage over the first load L1 when $I_{L1} > 0$, e.g. when the first load L1 is active or powered.

$\Delta U_{VS} = U_{VS\_Inactive} - U_{VS\_Active}$, wherein $U_{VS\_Inactive}$ is the terminal voltage of the voltage source when $I_{L1} = 0A$, e.g. when the first load L1 is inactive, in sleep mode, disconnected or non-powered, and $U_{VS\_Active}$ is the terminal voltage of the voltage source when $I_{L1} > 0$, e.g. when the first load L1 is active or powered, regardless of the current level $I_{L1}$ of the first load L1.

$I_{L1\_Active}$ corresponds to the current level $I_{L1}$ of the first load L1 when $I_{L1} > 0$, e.g. when the first load L1 is active or powered.

In other form, the equation for calculating the resistance value $R_{Wire\_L1}$ of the section S may be written:

$$R_{Wire\_L1} = \frac{(U_{L1\_Inactive} - U_{L1\_Active}) - (U_{VS\_Inactive} - U_{VS\_Active})}{I_{L1\_Active}}$$

.

The first load L1 may for example be a safety critical electrical load, such as for example an electrically operated vehicle brake system, or a part thereof, or an electrically operated vehicle steering system, or a part thereof, or the like.

Consequently, the method is suitable for determining a resistance value of a section of a vehicle power distribution wiring harness that is connecting a vehicle DC voltage source 1 with a first vehicle electrical load L1 and with a second vehicle electrical load L2.

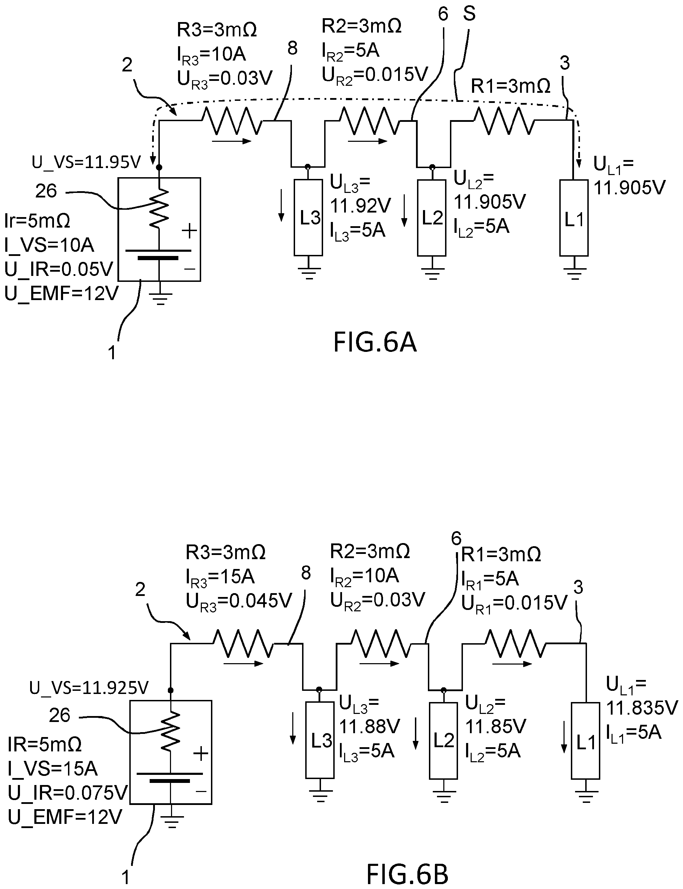

Figures 6A-11B illustrate various example electrical circuit layouts including measured data of relevant parameters, in both active and inactive operating state of the first load L1, for describing that the present method and system may be applied to a large variety of circuit layouts while still being useful for accurately and reliably enabling determining the resistance value a selective section of the power distribution wiring harness.

In the examples of figures 6A-11B, some example values of the internal resistance R1-R4 of the various sections 3, 6, 8 of the power distribution wiring harness 2, and the internal resistance 26 of the voltage source 1, are given for showing via backward calculation that the resistance equation provides a correct calculation of the total resistance value of the desired section S. However, in real life implementation of the method and system for determining a resistance value of a section of a power distribution wiring harness according to the disclosure, said internal resistance R1-R4 of the various sections 3, 6, 8 of the power distribution wiring harness are of course not known. They are unknown and need to be determined by means of the method and system of the present disclosure.

In the example of fig. 6A-B, the internal resistances R1-R3 of the first to third sections 3, 6, 8 are R1 = R2 = R3 = 3mΩ, i.e. 9 mΩ in total, while the internal resistance IR of the battery 1 is 5 mΩ.

In figure 6A, the first electrical load L1 is set in inactive operating state, and the second and third electrical loads L2 and L3 are each set in active operating state and consumes five Amperes (A) each, i.e. $I_{L2} = I_{L3}$ = 5A. The voltage source 1 thus delivers 10A, Ivs=10A. According to Ohm's law and backward calculation, the voltage drop $U_{IR}$ over the internal resistance 26 is calculated by equation $U_{IR}$= $I_{VS}$ * Ir = 10A * 0,005Ω = 0.05V.

U_EMF is in this example 12V, i.e. terminal voltage Uvs of the voltage source 1 in unloaded state. Consequently, when the first load L1 is inactive and the second and third loads L2, L3 are active, as depicted in the operating state of figure 6A, the terminal voltage $U_{VS\_Inactive}$ of the voltage source 1 in the operating state of figure 6A is calculated by 12V - 0.05V = 11.95V.

The voltage drop $U_{R3}$ over the third section 8 of the power distributing wiring harness 2 is backward calculated using Ohm's law: $U_{R3}$ = $R_3$ * $I_{R3}$ = 0.003Ω * 10A = 0.03 V. Consequently, the voltage over the third load L3 is calculated according to $U_{L3}$ = Uvs - $U_{R3}$ = 11.95V - 0.03V = 11.92V.

The voltage drop $U_{R2}$ over the second section 6 of the power distributing wiring harness 2 is calculated according to Ohm's law: $U_{R2}$ = $R_2$ * $I_{R2}$ = 0.003Ω * 5A = 0.015V. Consequently, the voltage over the second load L2 is calculated according to $U_{L2}$ = $U_{L3}$ - $U_{R2}$ = 11.92V - 0.015V = 11.905V.

The voltage drop $U_{R1}$ over the first section 3 of the power distributing wiring harness 2 is zero because there is no current flowing through the first section 3 in the inactive operating state of the first load L1. Consequently, the voltage $U_{L1\_Inactive}$ over the first load L1 in inactive operating state of the first load L1 is equal to the voltage drop over the second load L2, i.e. $U_{L1}$ = $U_{L2}$ = 11.905V.

In figure 6B, the first electrical load L1 is set in active operating state, and the second and third electrical loads L2 and L3 remain in the active operating state, and each of said loads consumes five Amperes (A) each, i.e. $I_{L1} = I_{L2} = I_{L3}$ = 5A. $I_{L1\_Active}$ is thus 5 A, and the voltage source 1 thus delivers 15A, Ivs=15A. According to Ohm's law, the voltage drop $U_{IR}$ over the internal resistance 26 is calculated by equation $U_{IR}$ = Ivs * Ir = 15A * 0,005Ω = 0.075V.

The terminal voltage $U_{VS\_Active}$ of the voltage source 1 in the operating state of figure 6B is calculated by 12V - 0.075V = 11.925V.

The voltage drop $U_{R3}$ over the third section 8 of the power distributing wiring harness 2 is calculated according to Ohm's law: $U_{R3}$ = $R_3$ * $I_{R3}$ = 0.003Ω * 15A = 0.045V. Consequently, the voltage over the third load L3 is calculated according to $U_{L3}$ = Uvs - $U_{R3}$ = 11.925V - 0.045V = 11.88V.

The voltage drop $U_{R2}$ over the second section 6 of the power distributing wiring harness 2 is calculated according to Ohm's law: $U_{R2}$ = R2 * $I_{R2}$ = 0.003Ω * 10A = 0.03V. Consequently, the voltage over the second load L2 is calculated according to $U_{L2}$ = $U_{L3}$ - $U_{R2}$ = 11.88V - 0.03V = 11.85V.

The voltage drop $U_{R1}$ over the first section 3 of the power distributing wiring harness 2 is calculated according to Ohm's law: $U_{R1}$ = R1 * $I_{R1}$ = 0.003Ω * 5A = 0.015V. Consequently, the voltage $U_{L1\_Active}$ over the first load L1 in the active operating state of the first load L1 is calculated according to $U_{L1}$ = $U_{L2}$ - $U_{R1}$ = 11.85V - 0.015V = 11.835V.

In a real life implementation of the present system and method for determining the resistance value of a section of the power distribution wiring harness 2, these values of the electrical system, i.e. the terminal voltage $U_{VS\_Inactive}$ of the voltage source 1 in inactive operating state of the first load L1, the voltage $U_{L1\_Inactive}$ over the first load L1 in inactive operating state of the first load L1, the terminal voltage $U_{VS\_Active}$ of the voltage source 1 in the active operating state of the first load L1, the voltage $U_{L1\_Active}$ over the first load L1 in the active operating state of the first load L1, and the current $I_{L1\_Active}$ through the firs load L1 in the active operating state of the first load L1, would be determined by measurements of the actual electrical circuit, and not by backward calculation.

After having obtained these values of the electrical system in active and inactive operating state of the first electrical load L1, the resistance value $R_{Wire\_L1}$ of the section S of the electrical circuit can be determined by applying the following equation:

$$R_{Wire\_L1} = \frac{(U_{L1\_Inactive}-U_{L1\_Active})-(U_{VS\_Inactive}-U_{VS\_Active})}{I_{L1\_Active}} =$$

$$\frac{(11.905-11.835)-(11.95-11.925)}{5} = 9m\Omega.$$

This is correct because $R_{Wire\_L1}$ = R1 + R2 + R3 = 9 mΩ.

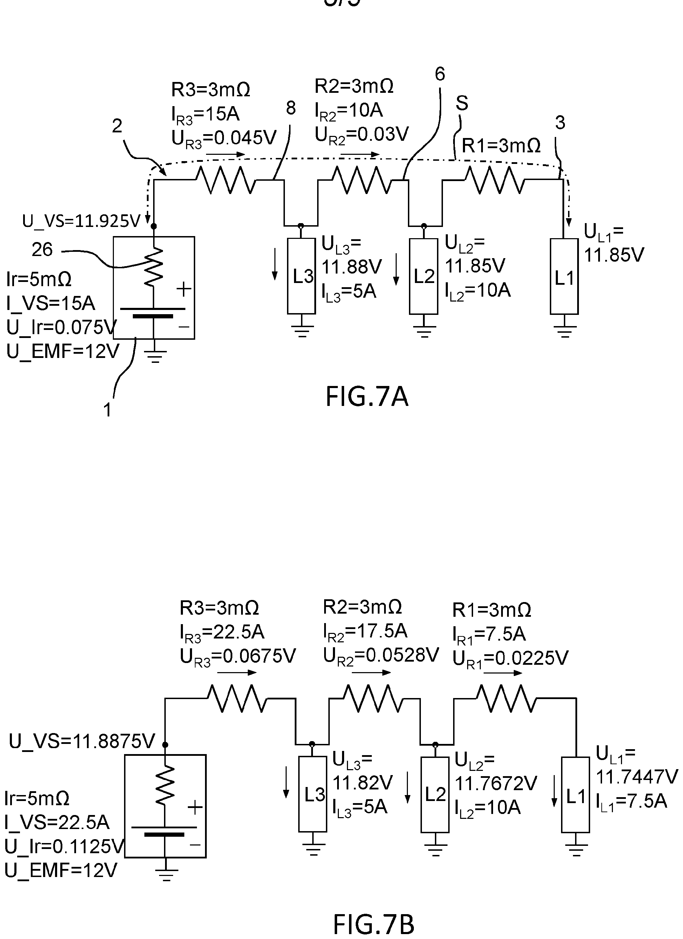

In the example of fig. 7A-B, the method for calculating the resistance value $R_{Wire\_L1}$ of the section S is applied on a similar electrical circuit, but wherein the electrical loads are different. In particular, $I_{L3}$ = 5A, $I_{L2}$ = 10A, and $I_{L1}$ = 7.5 A in active operating state of the first load L1. $I_{L1\_Active}$ is thus 7.5 A.

By applying the same backward calculation as described above with reference to fig. 6A-6B, the following values of the relevant parameters can be backwards calculated: $U_{VS\_Inactive}$=11.925V, $U_{L1\_Inactive}$=11.85V, $U_{VS\_Active}$=11.8875V, $U_{L1\_Active}$=11.7447V and $I_{L1\_Active}$=7.5A. When assuming that these values are obtained by measurements on the real electrical circuit in active and inactive operating state of the first electrical load L1, the following equation can be applied for calculating the resistance value $R_{Wire\_L1}$ of the section S of the electrical circuit of fig. 7A-7B:

$$R_{Wire\_L1} = \frac{(U_{L1\_Inactive}-U_{L1\_Active})-(U_{VS\_Inactive}-U_{VS\_Active})}{I_{L1\_Active}} =$$

$$\frac{(11.85-11.7447)-(11.925-11.8875)}{7.5} = 9m\Omega.$$

This is correct because $R_{Wire\_L1}$ = R1 + R2 + R3 = 9 mΩ in the example of figures 7A-7B.

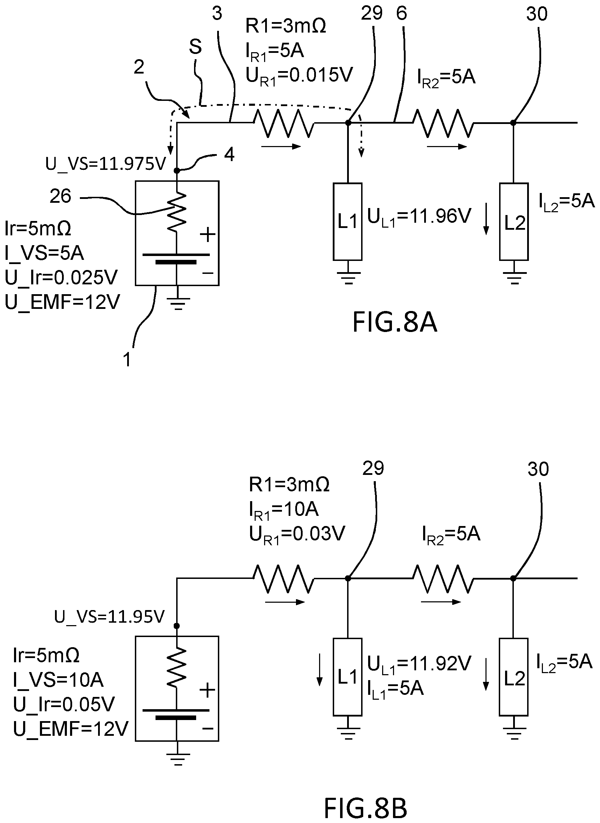

In the example of fig. 8A-B, the electrical circuit merely includes two electrical loads, i.e. first and second electrical loads L1, L2. Moreover, the first load L1 is here located closer to the voltage source 1, i.e. upstream of the second electrical load L2. However, the system and method for determining the resistance value of a section of the power distribution wiring harness 2 according to the present disclosure is applicable also for this electrical layout, as described in detail below.

Specifically, the power distribution wiring harness 2 comprises two interconnected wire sections 3, 6, wherein the first wire section 3 connects the positive terminal of the DC voltage source 1 with the positive terminal of the first electrical load L1, and the second wire section 6 is connecting the positive terminal of the second electrical load L2 with the positive terminal of the first electrical load L1.

Moreover, in this example, we assume that the resistance R1 of the first section 3 is 3 mΩ, while the internal resistance IR of the battery 1 is for example 5 mΩ.

In figure 8A, the first electrical load L1 is set in inactive operating state, and the second electrical load L2 is set in active operating state and consumes 5A. The voltage source 1 thus delivers 5A, Ivs=5A. According to Ohm's law, the voltage drop $U_{IR}$ over the internal resistance 26 is calculated by equation $U_{IR}$= Ivs * Ir = 5A * 0,005Ω = 0.025V.

The terminal voltage $U_{VS\_Inactive}$ of the voltage source 1 in the operating state of figure 8A is calculated by 12V - 0.025V = 11.975V.

The voltage drop $U_{R1}$ over the first section 3 of the power distributing wiring harness 2 is calculated according to Ohm's law: $U_{R1}$ = $R_1$ * $I_{R1}$ = 0.003Ω * 5A = 0.015V. Consequently, the voltage over the first load L1 in inactive operating state of the first load L1 is calculated according to $U_{L1\_Inactive}$ = Uvs - $U_{R1}$ = 11.975V - 0.015V = 11.96V.

In figure 8B, the first electrical load L1 is set in active operating state, and electrical load L2 remains in the active operating state, and each of said loads consumes 5A each, i.e. $I_{L1\_Active}$ = $I_{L2}$ = 5A. The voltage source 1 thus delivers 10A, Ivs=10A. According to Ohm's law, backward calculation of the voltage drop $U_{IR}$ over the internal resistance 26 may be calculated by equation $U_{IR}$= Ivs * Ir = 10A * 0,005Ω = 0.05V.

The terminal voltage $U_{VS\_Active}$ of the voltage source 1 in the operating state of figure 8B is calculated by 12V - 0.05V = 11.95V.

The voltage drop $U_{R1}$ over the first section 3 of the power distributing wiring harness 2 is calculated according to Ohm's law: $U_{R1}$ = $R_1$ * $I_{R1}$ = 0.003Ω * 10A = 0.03V. Consequently, the voltage $U_{L1\_Active}$ over the first load L1 in active operating state of the first load L1 is calculated according to $U_{L1\_Active}$ = Uvs - $U_{R1}$ = 11.95V - 0.03V = 11.92V.

When assuming that these voltage and current levels are obtained by measurements on the real electrical circuit in active and inactive operating state of the first electrical load L1, the following equation can be applied for calculating the resistance value $R_{Wire\_L1}$ of the section S of the electrical circuit of fig. 8A-8B:

$$R_{Wire\_L1} = \frac{(U_{L1\_Inactive} - U_{L1\_Active}) - (U_{VS\_Inactive} - U_{VS\_Active})}{I_{L1\_Active}} =$$

$$\frac{(11.96 - 11.92) - (11.975 - 11.95)}{5} = 3m\Omega.$$

This is correct because $R_{Wire\_L1}$ = R1 = 3 mΩ.

It has thus been shown that the method for calculating the resistance value R_Wire_L1 of a section S of the power distribution wiring harness 2 connecting the DC voltage source 1 with the first electrical load L1 can applied in a general manner for various layouts of the electric circuit, for example with two or three loads, and with different internal location of the first load within the electrical circuit.

Specifically, the present disclosure provides a method for determining a resistance value R_Wire_L1 of a section S of a power distribution wiring harness 2 connecting a DC voltage source 1 with a first electrical load L1 and with a second electrical load L2, wherein a supply current to the first and second electrical loads L1, L2 is configured to be routed partly through a common electrical conductor of said power distribution wiring harness. The method comprises a step of obtaining, during a first detection event in which the first electrical load is in an inactive operating state, the terminal voltage level of the DC voltage source U_VS_Inactive and voltage level of the first electrical load U_L1_Inactive. The method further comprises a step of obtaining, during a second detection event in which the first electrical load is in an active operating state, terminal voltage level of the DC voltage source U_VS_Active, the voltage level of the first electrical load U_L1_Active and an electrical current level I_L1_Active of the first electrical load L1, i.e. the electrical current level I_L1_Active flowing through the first electrical load L1. The method additionally comprises a step of calculating the resistance value R_Wire_L1 of the section of the power distribution wiring harness that is connecting the DC voltage source with the first electrical load L1 based on the obtained: terminal voltage level of the DC voltage source in the inactive operating state U_VS_Inactive; voltage level of the first electrical load in the inactive operating state U_L1_Inactive; terminal voltage level of the DC voltage source in the active operating state U_VS_Active; voltage level of the first electrical load in the active operating state U_L1_Active; and electrical current level of the first electrical load L1 in the active operating state I_L1_Active.

More in detail, the method described above involves calculating the resistance value R_Wire_L1 of the section of the power distribution wiring harness that is connecting the DC voltage source with the first electrical load L1 based on the following equation:

$$R_{Wire\_L1} = \frac{(U_{L1\_Inactive} - U_{L1\_Active}) - (U_{VS\_Inactive} - U_{VS\_Active})}{I_{L1\_Active}},$$

wherein R_Wire_L1 is the resistance value of the section of the power distribution wiring harness, U_L1_Inactive is the voltage level of the first electrical load in the inactive operating state, U_L1_Active is the voltage level of the first electrical load in the active operating state, U_VS_Inactive is the terminal voltage level of the DC voltage source in the inactive operating state, U_VS_Active is the terminal voltage level of the DC voltage source in the active operating state, and I_L1_Active is the electrical current level of the first electrical load L1 in the active operating state.

As a result, a cost-efficient, reliable and fast method for determining an internal wire resistance value of a section S of a power distribution wiring harness 2 is provided, wherein a DC supply current routed to the first and second electrical loads L1, L2 through a common, i.e. shared, electrical conductor of said power distribution wiring harness.

Moreover, the method for determining a resistance value R_Wire_L1 of a section S of a power distribution wiring harness 2 according to the present disclosure enables provision of a power distribution wiring harness that is free from being connected to a dedicated resistance measuring control system. A dedicated resistance measuring control system is typically configured for routing a dedicated resistance measuring current through a selected section of a power distribution wiring harness by connecting a dedicated DC voltage source to the ends of the section of the wiring harness to be measured, while keeping all loads of the electrical circuit in inactive state.

For shifting the first electrical load L1 between active and inactive operating states, the method described above comprises a step of setting or ensuring that the first electrical load L1 is set in the inactive operating state. For the same reason, the method described above comprises a step of setting or ensuring that the first electrical load L1 is set in the active operating state.

The length of the shared or common electrical conductor, i.e. the part of the power distributing wiring harness that conveys electrical power to both the first and second loads L1, L2 through a single conductor is generally at least 0.3m long, specifically at least 0.5 m long.

As mentioned above, it is desirable that the current flow levels of the electrical loads that are kept active during both the first and second detection events are approximately equal during the first and second detection events, and that the current flow levels of the electrical loads that are kept inactive during both the first and second detection events are approximately equal during the first and second detection events, for providing an accurate determination of the resistance value R_Wire_L1 I of the section of the power distribution wiring harness.

In other words, during a detection sequence for determining the resistance value R_Wire_L1 I of a section of the power distribution wiring harness extending from the voltage source to the first electrical load L1, the individual current consumption of the second electrical load L2 is maintained substantially identical during the first and second detection events, such as for example X ampere. Similarly, the individual current consumption of for example the third electrical load L3 is also maintained substantially identical during the first and second detection events, such as for example Y ampere. However, the individual current consumption of the second electrical load L2 may be different from the individual current consumption of the third electrical load L3, i.e. X may be different from Y. The term equal here refers merely to each load individually.

Maintaining the individual current consumption of said second and other loads L2-L4 substantially identical may correspond to keeping the current within a certain interval, such as within +/- 10%, specifically within +/- 5%, more specifically within +/- 1%, during the first and second detection events.

The various loads may thus have different current consumptions during the first detection events, but all loads except the first load should preferably have approximately the same current level during first and second detection events, respectively.

In some example embodiments, the method may thus include a step of obtaining, during each of the first and second detection events, electrical current level of the second electrical load L2, and any other electrical load L3, L4 that is/are connected to the DC voltage source via the power distribution wiring harness. Thereby, it can be verified that the current level of each individual load L2-L4 different from the first load L1 is substantially the same during the first and second detection events.

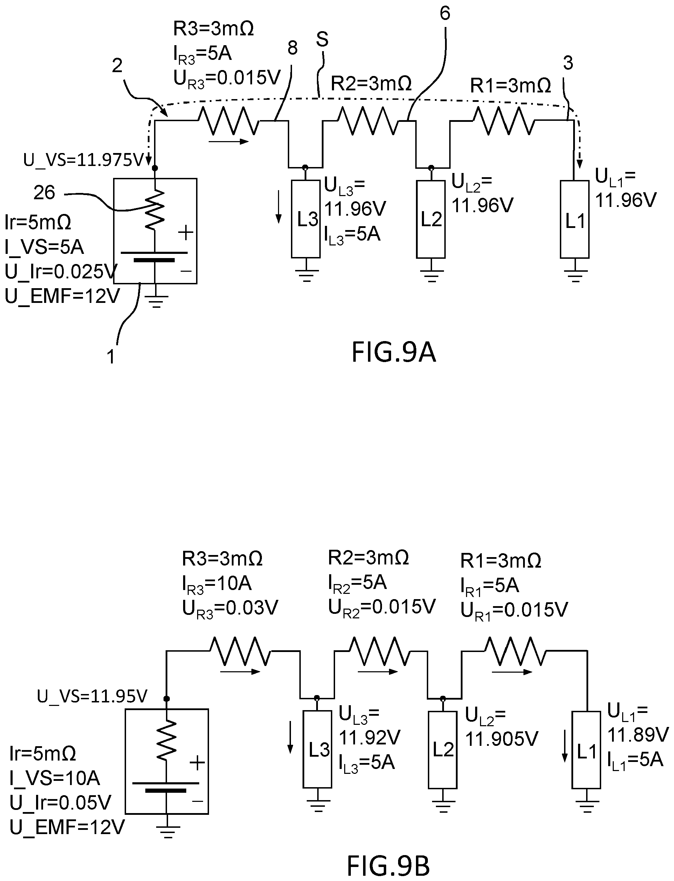

Figures 9A-11B show that the method according to the disclosure may be applied to three further example electrical circuit layouts and/or positions of the first load L1, thereby proving the methods usefulness.

In the example embodiment of figure 9A-9B, the electrical circuit layout and the currents consumption of the loads, the resistance values R1-R3 of the first to third sections 3, 6, 8 and the internal resistance IR of the battery 1 are all the same as described above with reference to figure 6, but here the second load L2 is inactive during both detection events.

In figure 9A, the first and second electrical loads L1 and L2 are set in inactive operating state, and the third electrical load L3 is set in active operating state and consumes 5A. The voltage source 1 thus delivers 10A, and the voltage drop $U_{IR}$ over the internal resistance 26 is calculated by equation $U_{IR}$= Ivs * Ir = 5A * 0,005Ω = 0.025V. Consequently, the terminal voltage $U_{VS\_Inactive}$ of the voltage source 1 is equal to: 12V - 0.025V = 11.975V.

The voltage drop $U_{R3}$ over the third section 8 of the power distributing wiring harness 2 is: $U_{R3} = R_3 * I_{R3} = 0.003Ω * 5A = 0.015V$. Consequently, the voltage over the third load L3 is calculated according to $U_{L3} = Uvs - U_{R3} = 11.975V - 0.015V = 11.96V$.

The voltage drop $U_{R2}$ over the second section 6 of the power distributing wiring harness 2 is calculated according to Ohm's law: $U_{R2} = R_2 * I_{R2} = 0.003Ω * 5A = 0.015V$. Consequently, the voltage over the second load L2 is calculated according to $U_{L2} = U_{L3} - U_{R2} = 11.92V - 0.015V = 11.905V$.

The voltage drop $U_{R2}$ over the second section 6 and $U_{R1}$ over the first section 3 of the power distributing wiring harness 2 is zero because there is no current flowing through the first and second sections 3, 6 in the inactive operating state of the first and second loads L1, L2. Consequently, the voltage $U_{L1\_Inactive}$ over the first load L1 in inactive operating state of the first load L1 is equal to the voltage drop over the third load L2, i.e. $U_{L1} = U_{L2} = U_{L3} = 11.96V$.

In figure 9B, the first electrical load L1 is set in active operating state, the second electrical load L2 remain in the inactive operating state and the third electrical load L3 remain in the active operating state, and each of first and third loads consumes 5A, i.e. $I_{L1} = I_{L3} = 5A$. The voltage source 1 thus delivers 10A, and the voltage drop $U_{IR}$ over the internal resistance 26 is: $U_{IR}$= Ivs * Ir = 10A * 0,005Ω = 0.05V.

The terminal voltage $U_{VS\_Active}$ of the voltage source 1 in the operating state of figure 9B is: 12V - 0.05V = 11.95V.

The voltage drop $U_{R3}$ over the third section 8 of the power distributing wiring harness 2 is: $U_{R3} = R_3 * I_{R3} = 0.003Ω * 10A = 0.03V$. Consequently, the voltage over the third load L3 is: $U_{L3} = Uvs - U_{R3} = 11.95V - 0.03V = 11.92V$.

The voltage drop $U_{R2}$ over the second section 6 of the power distributing wiring harness 2: $U_{R2} = R2 * I_{R2} = 0.003Ω * 5A = 0.015V$. Consequently, the voltage over the second load L2 is: $U_{L2} = U_{L3} - U_{R2} = 11.92V - 0.015V = 11.905V$.

The voltage drop $U_{R1}$ over the first section 3 of the power distributing wiring harness 2 is: $U_{R1} = R1 * I_{R1} = 0.003Ω * 5A = 0.015V$. Consequently, the voltage $U_{L1\_Active}$ over the first load L1 in the active operating state of the first load L1 is calculated according to $U_{L1} = U_{L2} - U_{R1} = 11.905V - 0.015V = 11.89V$.

Using these values when applying the equation for calculating the resistance value $R_{Wire\_L1}$ of the section S

gives:

$$R_{Wire\_L1} = \frac{(U_{L1\_Inactive} - U_{L1\_Active}) - (U_{VS\_Inactive} - U_{VS\_Active})}{I_{L1\_Active}} =$$

$$\frac{(11.96 - 11.89) - (11.975 - 11.95)}{5} = 9m\Omega.$$

This is correct because $R_{Wire\_L1} = R1 + R2 + R3 = 9\,m\Omega$. Hence, the method is applicable also when there are one or more inactive loads located between the first load and the voltage source 1.

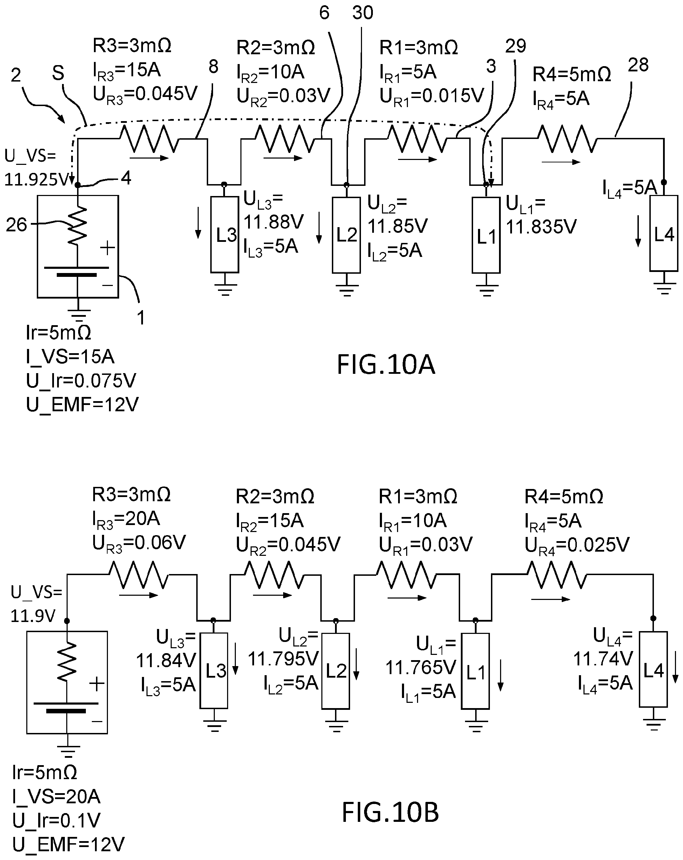

In the example embodiment of figure 10A-10B, the electrical circuit layout and the currents consumption of the loads, the resistance values R1-R3 of the first to third sections 3, 6, 8 and the internal resistance IR of the battery 1 are all the same as described above with reference to figure 6, with the difference that a fourth load L4 is connected to the voltage source 1 via a fourth section 28 of the power distribution wiring harness 2 that is located outside of the first load L1 and having an internal resistance R4, wherein the fourth load L4 is active during both the first and second detection events.

In figure 10A, the first electrical load L1 is set in inactive operating state, and the second to fourth electrical loads L2, L3 and L4 are set in active operating state and consumes 5A each. The voltage source 1 thus delivers 15A, and the voltage drop $U_{IR}$ over the internal resistance 26 is calculated by equation $U_{IR}$= Ivs * Ir = 15A * 0,005$\Omega$ = 0.075V. Consequently, the terminal voltage $U_{VS\_Inactive}$ of the voltage source 1 is equal to: 12V - 0.075V = 11.925V.

The voltage drop $U_{R3}$ over the third section 8 of the power distributing wiring harness 2 is: $U_{R3} = R_3 * I_{R3} = 0.003\Omega *$ 15A = 0.045V. Consequently, the voltage over the third load L3 is calculated according to $U_{L3}$ = Uvs - $U_{R3}$ = 11.925V - 0.045V = 11.88V.

The voltage drop $U_{R2}$ over the second section 6 of the power distributing wiring harness 2 is calculated according to Ohm's law: $U_{R2} = R_2 * I_{R2} = 0.003\Omega * 10A = 0.03V$. Consequently, the voltage over the second load L2 is calculated according to $U_{L2} = U_{L3} - U_{R2} = 11.88V - 0.03V = 11.85V$.

The voltage drop $U_{R1}$ over the first section 3 of the power distributing wiring harness 2 is calculated according to Ohm's law: $U_{R1} = R1 * I_{R1} = 0.003\Omega * 5A = 0.015V$. Consequently, the voltage $U_{L1\_Inactive}$ over the first load L1 in inactive operating state of the first load L1 is calculated according to $U_{L2} = U_{L3} - U_{R2} = 11.85V - 0.015V = 11.835V$.

In figure 10B, the first electrical load L1 is set in active operating state, and the other electrical loads L2-L4 remain in the active operating state, each consuming 5A, i.e. $I_{L1} = I_{L2} = I_{L3} = I_{L4} = 5A$. The voltage source 1 thus delivers 20A, and the voltage drop $U_{IR}$ over the internal resistance 26 is: $U_{IR}$= $I_{VS}$ * Ir = 20A * 0,005$\Omega$ = 0.1V.

The terminal voltage $U_{VS\_Active}$ of the voltage source 1 in the operating state of figure 10B is: 12V - 0.1V = 11.9V.

The voltage drop $U_{R3}$ over the third section 8 of the power distributing wiring harness 2 is: $U_{R3} = R_3 * I_{R3} = 0.003\Omega *$ 20A = 0.06V. Consequently, the voltage over the third load L3 is: $U_{L3}$ = Uvs - $U_{R3}$ = 11.9V - 0.06V = 11.84V.

The voltage drop $U_{R2}$ over the second section 6 of the power distributing wiring harness 2: $U_{R2} = R2 * I_{R2} = 0.003\Omega * 15A = 0.045V$. Consequently, the voltage over the second load L2 is: $U_{L2} = U_{L3} - U_{R2} = 11.84V - 0.045V = 11.795V$.

The voltage drop $U_{R1}$ over the first section 3 of the power distributing wiring harness 2 is: $U_{R1} = R1 * I_{R1} = 0.003\Omega *$ 10A = 0.03V. Consequently, the voltage $U_{L1\_Active}$ over the first load L1 in the active operating state of the first load L1 is calculated according to $U_{L1} = U_{L2} - U_{R1} = 11.795V - 0.03V = 11.765V$.

Using these value when applying the equation for calculating the resistance value $R_{Wire\_L1}$ of the section S gives:

$$R_{Wire\_L1} = \frac{(U_{L1\_Inactive} - U_{L1\_Active}) - (U_{VS\_Inactive} - U_{VS\_Active})}{I_{L1\_Active}} =$$

$$\frac{(11.835 - 11.765) - (11.925 - 11.9)}{5} = 9m\Omega.$$

This is correct because $R_{Wire\_L1} = R1 + R2 + R3 = 9\,m\Omega$. Hence, the method is applicable also when there are one or more active loads located after the first load and the voltage source 1.

As described above with reference to figure 8A-8B, a branch-off point 29, or junction point, of the first electrical load L1 along the wiring harness 2 may be located upstream of the second electrical load L2, i.e. closer to the DC voltage source, as seen along the length of the power distribution wiring harness 2.

Alternatively, as described above with reference to figure 10A-10B, the branch-off point 30, or junction point, of the second electrical load L2 may be located upstream of the first electrical load L1, i.e. closer to the DC voltage source, as seen along the length of the power distribution wiring harness 2.

In the schematic layout of fig. 8A, the common electrical conductor of said power distribution wiring harness that routes the supply current to both the first and second electrical loads L1, L2 extends from a region close to, or at the positive terminal 4 of the voltage source 1 to the branch-off point 29 of the first electrical load L1.

However, in the schematic layout of fig. 10A, the common electrical conductor of said power distribution wiring harness that routes the supply current to both the first and second electrical loads L1, L2 extends from a region close to, or at the positive terminal 4 of the voltage source 1 to the branch-off point 30 of the second electrical load L1.

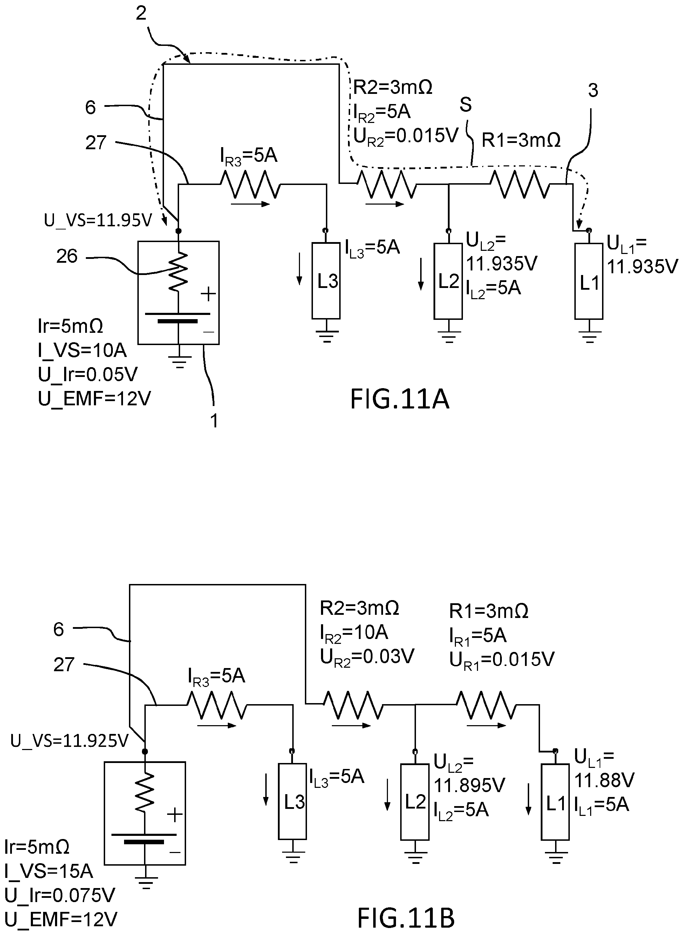

In the example embodiment of figure 11A-11B, the currents consumption of the first to third loads L1-L3, the resistance values of the first to third sections 3, 6, 8 and the internal resistance IR of the battery 1 are all the same as described above with reference to figure 6, with the exception that the electrical circuit layout is different. Here, the first and second electrical loads L1, L2 are connected to the DC voltage source 1 via a common power supply wiring harness 2, while the third load L3 is connected to the voltage source 1 via a separate wiring 27.

In figure 11A, the first electrical load L1 is set in inactive operating state, and the second the third electrical loads L2, L3 are set in active operating state and consumes 5A each. The voltage source 1 thus delivers 10A, and the voltage drop $U_{IR}$ over the internal resistance 26 is calculated by equation $U_{IR}=$ Ivs * Ir = 10A * 0,005Ω = 0.05V. Consequently, the terminal voltage $U_{VS\_Inactive}$ of the voltage source 1 is equal to: 12V - 0.05V = 11.95V.

The voltage drop $U_{R2}$ over the second section 6 of the power distributing wiring harness 2 is calculated according to Ohm's law: $U_{R2} = R_2 * I_{R2} = 0.003Ω * 5A = 0.015V$. Consequently, the voltage over the second load L2 is calculated according to $U_{L2} = Uvs - U_{R2} = 11.95V - 0.015V = 11.935V$.

The voltage drop $U_{R1}$ over the first section 3 of the power distributing wiring harness 2 is zero because there is no current flowing through the first section 3 in the inactive operating state of the first load L1. Consequently, the voltage $U_{L1\_Inactive}$ over the first load L1 in inactive operating state of the first load L1 is equal to the voltage drop over the second load L2, i.e. $U_{L1} = U_{L2} = 11.935V$.

In figure 11B, the first electrical load L1 is set in active operating state, and the other electrical loads L2-L3 remain in the active operating state, each consuming 5A, i.e. $I_{L1} = I_{L2} = I_{L3} = 5A$. The voltage source 1 thus delivers 15A, and the voltage drop $U_{IR}$ over the internal resistance 26 is: $U_{IR}= I_{VS} * Ir = 15A * 0,005Ω = 0.075V$.

The terminal voltage $U_{VS\_Active}$ of the voltage source 1 in the operating state of figure 10B is: 12V - 0.075V = 11.925V.

The voltage drop $U_{R2}$ over the second section 6 of the power distributing wiring harness 2: $U_{R2} = R2 * I_{R2} = 0.003Ω * 10A = 0.03V$. Consequently, the voltage over the second load L2 is: $U_{L2} = Uvs - U_{R2} = 11.925V - 0.03V = 11.895V$.

The voltage drop $U_{R1}$ over the first section 3 of the power distributing wiring harness 2 is: $U_{R1} = R1 * I_{R1} = 0.003Ω * 5A = 0.015V$. Consequently, the voltage $U_{L1\_Active}$ over the first load L1 in the active operating state of the first load L1 is calculated according to $U_{L1} = U_{L2} - U_{R1} = 11.895V - 0.015V = 11.88V$.

Using these values when applying the equation for calculating the resistance value $R_{Wire\_L1}$ of the section S gives:

$$R_{Wire\_L1} = \frac{(U_{L1\_Inactive}-U_{L1\_Active})-(U_{VS\_Inactive}-U_{VS\_Active})}{I_{L1\_Active}} =$$

$$\frac{(11.935-11.88)-(11.95-11.925)}{5} = 6mΩ.$$

This is correct because $R_{Wire\_L1}$ = R1 + R2 = 6 mΩ. Hence, the method is applicable also when there are one or more active loads connected to the voltage source 1 via separate wiring 27.

The method for determining the resistance value $R_{Wire\_L1}$ of a section S of the power distribution wiring harness described above is very useful when being implemented in a vehicle, because it allows the vehicle to monitor the resistance values of the power distribution wiring harness and to take action in case of high resistance values, for reducing risk of degraded operational reliability of electrical system, in particular safety critical electrical devices.

The action may for example involve activating a vehicle load reducing control strategy. Such a strategy may for example involve reducing the electrical power consumption of selected electrical loads, for reducing the load on the voltage source and avoiding undervoltage power supply to critical electrical loads. Reducing electrical power consumption of selected electrical loads may for example involve shifting operating setting to a low power consumption operating mode, and/or simply setting certain electrical loads in non-operational state, in particular convenience loads such as vehicle seat massage function, but possibly also large electrical loads such as vehicle air conditioning system, etc.

The action may for example also, or alternative, involve informing a vehicle user, for example via a vehicle HMI, such as displaying a sign or message to the user, that the vehicle needs maintenance, or the like.

The action may also, or alternatively, involve informing a remote vehicle service manager, such as a fleet manager; OEM, etc., for example by submitting vehicle information to remote vehicle service manager via telemetry, or by enabling remote server to connect to vehicle data communication interface, such as an API or the like, for downloading vehicle data, thereby enabling the remote vehicle service manager to take appropriate action.

In other words, the present disclosure also relates to a method for monitoring the vehicle electrical system comprising: recurringly in a periodic manner during the vehicle life time, obtaining a resistance value $R_{Wire\_L1}$ of a section S of the power distribution wiring harness of the vehicle as described above; comparing the obtained resistance value of the section of the power distribution wiring, or an associated voltage drop based on said resistance value, with a predetermined or adaptive threshold value; and activating a vehicle load reducing control strategy and/or informing a vehicle user and/or a remote vehicle service manager about power supply concern in response to determining that the calculated resistance value of the section of the power distribution wiring, or the voltage drop based on said resistance value, is larger than said the threshold value.

Such as monitoring check of the vehicle electrical system may for example be performed recurringly, in a regular or irregular manner, on a time and/or driving distance basis. For example, the monitoring check may be performed for example every week or every month, or the like, and/or at each 1000 km driving distance, or at each 5000 km driving distance, or the like.

With reference to fig. 1 to 11B, the present disclosure also relates to an electrical system for a vehicle comprising: a DC voltage source 1; a first electrical load L1; a second electrical load L2; a power distribution wiring harness 2 connecting the DC voltage source 1 with the first electrical load L1 and with the second electrical load L2, wherein the power distribution wiring harness is configured to route a supply current from the DC voltage source 1 to the first and second electrical loads L1, L2 through a common electrical conductor of said power distribution wiring harness 2; and an electronic control system configured for determining a resistance value of a section of the power distribution wiring harness, wherein the electronic control system is configured for: obtaining, during a first detection event in which the first electrical load is in an inactive operating state, terminal voltage level U_VS_Inactive of the DC voltage source 1 and voltage level U_L1_Inactive of the first electrical load L1; obtaining, during a second detection event in which the first electrical load L1 is in an active operating state, terminal voltage level U_VS_Active of the DC voltage source 1, the voltage level U_L1_Active of the first electrical load L1 and an electrical current level I_L1_Active of the first electrical load L1; and calculating the resistance value of the section of the power distribution wiring harness that is connecting the DC voltage source 1 with the first electrical load L1 based on the obtained: terminal voltage level U_VS_Inactive of the DC voltage source in the inactive operating state; voltage level U_L1_Inactive of the first electrical load in the inactive operating state; terminal voltage level U_VS_Active of the DC voltage source in the active operating state; voltage level U_L1_Active of the first electrical load in the active operating state; and electrical current level I_L1_Active of the first electrical load L1 in the active operating state.

Specifically, the electronic control system may be configured for calculating the resistance value of the section of the power distribution wiring harness that is connecting the DC voltage source 1 based on the following equation:

$$R_{Wire\_L1} = \frac{(U_{L1\_Inactive} - U_{L1\_Active}) - (U_{VS\_Inactive} - U_{VS\_Active})}{I_{L1\_Active}}.$$

In this equation, $R_{Wire\_L1}$ is the resistance value of the section of the power distribution wiring harness, $U_{L1\_Inactive}$ is the voltage level of the first electrical load in the inactive operating state, $U_{L1\_Active}$ is the voltage level of the first electrical load in the active operating state, $U_{VS\_Inactive}$ is the terminal voltage level of the DC voltage source in the inactive operating state, $U_{VS\_Active}$ is the terminal voltage level of the DC voltage source in the active operating state, and $I_{L1\_Active}$ is the electrical current level of the first electrical load (L1) in the active operating state.

In some example embodiments, at least one of the first and second electrical load is an electronic control unit (ECU) configured for controlling a function of the vehicle, in particular a safety critical function of the vehicle, such as vehicle steering or vehicle braking or vehicle autonomous driving. In such circumstances, the electrical system for a vehicle as described above is particularly useful, because it enables reduced risk for poor operational reliability of the electrical loads of the vehicle.

The present disclosure also relates to an electrical system that is configured for: recurringly in a periodic manner during the vehicle life time, obtaining a resistance value $R_{Wire\_L1}$ of a section S of the power distribution wiring harness of the vehicle as described above; comparing the obtained resistance value of the section of the power distribution wiring, or a voltage drop based on said resistance value, with a threshold value; and activating a vehicle load reducing control strategy and/or informing a vehicle user and/or a remote vehicle service manager about power supply concern in response to determining that the calculated resistance value of the section of the power distribution wiring, or the voltage drop based on said resistance value, is larger than the threshold value.

In other words, the system according to the vehicle is not only configured to monitor the resistance value of a section of the power distribution wiring harness, but also to implement such a monitoring system together with an action plan involving a special control strategy. Thereby, the system provides real improvement to the vehicle operational reliability.

The present disclosure has been presented above with reference to specific embodiments. However, other embodiments than the above described are possible and within the scope of the disclosure. Different method steps than those described above, performing the method by hardware or software, may be provided within the scope of the

**EP 4 671 774 A1**

disclosure.

The methods disclosed herein may be implemented in a general purpose computer, a processor, or a processor core. Suitable processors include, by way of example, a general purpose processor, a special purpose processor, a conventional processor, a digital signal processor (DSP), a plurality of microprocessors, one or more microprocessors in association with a DSP core, a controller, a microcontroller, Application Specific Integrated Circuits (ASICs), Field Programmable Gate Arrays (FPGAs) circuits, any other type of integrated circuit (IC), and/or a state machine.

The methods or flow charts provided herein may be implemented in a computer program, software, or firmware incorporated in a computer-readable storage medium for execution by a general purpose computer or a processor. Examples of computer-readable storage mediums include a read only memory (ROM), a random access memory (RAM), a register, cache memory, semiconductor memory devices, magnetic media such as internal hard disks and removable disks, magneto-optical media, and optical media such as CD-ROM disks, and digital versatile disks (DVDs).

Thus, according to an exemplary embodiment, there is provided a non-transitory computer-readable storage medium storing one or more programs configured to be executed by one or more processors of the system according to the disclosure, wherein the one or more programs comprising instructions for performing the method according to any one of the above-discussed embodiments. Alternatively, according to another exemplary embodiment a cloud computing system can be configured to perform any of the method aspects presented herein. The cloud computing system may comprise distributed cloud computing resources that jointly perform the method aspects presented herein under control of one or more computer program products. Moreover, the processor may be connected to one or more communication interfaces and/or sensor interfaces for receiving and/transmitting data with external entities such as e.g. sensors arranged on the vehicle surface, an off-site server, or a cloud-based server.

The processor(s) associated with the electronic control system described herein may be or include any number of hardware components for conducting data or signal processing or for executing computer code stored in memory. The system may have an associated memory, and the memory may be one or more devices for storing data and/or computer code for completing or facilitating the various methods described in the present description. The memory may include volatile memory or non-volatile memory. The memory may include database components, object code components, script components, or any other type of information structure for supporting the various activities of the present description. According to an exemplary embodiment, any distributed or local memory device may be utilized with the systems and methods of this description. According to an exemplary embodiment the memory is communicably connected to the processor (e.g., via a circuit or any other wired, wireless, or network connection) and includes computer code for executing one or more processes described herein.

It will be appreciated that the above description is merely exemplary in nature and is not intended to limit the present disclosure, its application or uses. While specific examples have been described in the specification and illustrated in the drawings, it will be understood by those of ordinary skill in the art that various changes may be made and equivalents may be substituted for elements thereof without departing from the scope of the present disclosure as defined in the claims. Furthermore, modifications may be made to adapt a particular situation or material to the teachings of the present disclosure without departing from the essential scope thereof. Further, the operations may be performed in any order and do not necessarily imply an order as provided. Specifically, the first and second detection events described herein may be performed in any order. In other words, the terms "first" and "second" do not define an order of events but are merely used for clearly distinguishing said events from each other. In other words, the second detection event may be performed before the first detection event, and opposite.

Therefore, it is intended that the present disclosure not be limited to the particular examples illustrated by the drawings and described in the specification as the best mode presently contemplated for carrying out the teachings of the present disclosure, but that the scope of the present disclosure will include any embodiments falling within the foregoing description and the appended claims. Reference signs mentioned in the claims should not be seen as limiting the extent of the matter protected by the claims, and their sole function is to make claims easier to understand.

REFERENCE SIGNS

1. Voltage source
2. Power distribution wiring harness
3. First wire section
4. Positive terminal voltage source
5. Positive terminal first electrical load
6. Second wire section
7. Positive terminal second electrical load
8. Third wire section

9. Positive terminal third electrical load
10. Fourth wire section
11. Positive terminal fourth electrical load
12. Main electrical conductor
13. Electrical connector
14. Ground connection voltage source
15. Ground connection electrical load
16. High-voltage voltage source
17. Plug-in connector
18. On-board charging converter
19. Electrical propulsion motor
20. Power converter
21. Vehicle
22. Chassis
23. Wheels
24. DC/DC converter
25. Electronic control system
26. Internal resistance
27. Separate wiring
28. Fourth section
29. Branch-off point first electrical load
30. Branch-off point second electrical load
L1. First electrical load
L2. Second electrical load
L3. Third electrical load
L4. Fourth electrical load
ECU. Electronic Control Unit
S. Section
R_Wire. Resistance value
U_VS_Inactive. Terminal voltage level in inactive state
U_L1_Inactive. Voltage level of first load in inactive state
U_VS_Active. Terminal voltage level in active state
U_L1_Active. Voltage level of first load in active state
I_L1_Active. Current level through first load in active state

**Claims**

1. A method for determining a resistance value (R_Wire_L1) of a section (S) of a power distribution wiring harness (2) connecting a DC voltage source (1) with a first electrical load (L1) and with a second electrical load (L2), wherein a supply current to the first and second electrical loads (L1, L2) is configured to be routed partly through a common electrical conductor of said power distribution wiring harness (2), the method comprising:

   obtaining, during a first detection event in which the first electrical load is in an inactive operating state, terminal voltage level (U_VS_Inactive) of the DC voltage source (1) and voltage level (U_L1_Inactive) of the first electrical load (L1);
   obtaining, during a second detection event in which the first electrical load (L1) is in an active operating state, terminal voltage level (U_VS_Active) of the DC voltage source (1), the voltage level (U_L1_Active) of the first electrical load (L1) and an electrical current level (I_L1_Active) of the first electrical load (L1);
   calculating the resistance value (R_Wire_L1) of the section (S) of the power distribution wiring harness (2) that is connecting the DC voltage source (1) with the first electrical load (L1) based on the obtained:

   terminal voltage level (U_VS_Inactive) of the DC voltage source (1) in the inactive operating state;
   voltage level (U_L1_Inactive) of the first electrical load (L1) in the inactive operating state;
   terminal voltage level (U_VS_Active) of the DC voltage source (1) in the active operating state;
   voltage level (U_L1_Active) of the first electrical load (L1) in the active operating state; and
   electrical current level (I_L1_Active) of the first electrical load (L1) in the active operating state.

**2.** The method according to claim 1, wherein the resistance value (R_Wire_L1) of the section (S) of the power distribution wiring harness (2) that is connecting the DC voltage source (1) with the first electrical load (L1) is calculated based on the following equation:

$$R_{Wire\_L1} = \frac{(U_{L1\_Inactive} - U_{L1\_Active}) - (U_{VS\_Inactive} - U_{VS\_Active})}{I_{L1\_Active}}.$$

**3.** The method according to any of the previous claims, wherein an individual current consumption of the second electrical load (L2), and any other electrical load (L3,L4) that is/are connected to the DC voltage source (1) via the power distribution wiring harness (2), is substantially identical during the first and second detection events.

**4.** The method according to any of the previous claims, further comprises the step of setting a switch associated with the first load (L1) in an open state during the first detection event.

**5.** The method according to any of the previous claims, wherein a current consumption of the first electrical load (L1) is substantially zero during the first detection event.

**6.** The method according to any of the previous claims, wherein the first and second detection events are performed consecutively within a short time span.

**7.** The method according to any of the previous claims, wherein the terminal voltage level (U_VS) of the DC voltage source (1) is detected by a voltage sensor connected over the DC voltage source (1), or by a battery management system (BMS) associated with the DC voltage source (1).

**8.** The method according to any of the previous claims, wherein the voltage level of the first electrical load (L1) is detected by a voltage sensor connected over the first electrical load (L1) or by a voltage sensor integrated in the first electrical load (L1).

**9.** The method according to any of the previous claims, wherein the inactive operating state of the first electrical load (L1) corresponds to a disconnected operating state, or a connected but temporarily non-used or non-activated or passive operating state.

**10.** The method according to any of the previous claims, further comprising a step of:

setting or ensuring that the first electrical load (L1) is set in the inactive operating state; and/or
setting or ensuring that the first electrical load (L1) is set in the active operating state.

**11.** The method according to any of the previous claims, further comprising:

comparing the calculated resistance value (R_Wire_L1) of the section (S) of the power distribution wiring harness (2), or a voltage drop based on said resistance value (R_Wire_L1), with a threshold value; and
activating a vehicle load reducing control strategy and/or informing a vehicle user and/or a remote vehicle service manager about power supply concern in response to determining that the calculated resistance value (R_Wire_L1) of the section (S) of the power distribution wiring harness (2), or the voltage drop based on said resistance value (R_Wire_L1), is larger than the threshold value.

**12.** An electrical system for a vehicle comprising:

a DC voltage source (1);
a first electrical load (L1);
a second electrical load (L2);
a power distribution wiring harness (2) connecting the DC voltage source (1) with the first electrical load (L1) and with the second electrical load (L2), wherein the power distribution wiring harness (2) is configured to route a supply current from the DC voltage source (1) to the first and second electrical loads (L1, L2) through a common electrical conductor of said power distribution wiring harness (2); and
an electronic control system (25) configured for determining a resistance value (R_Wire_L1) of a section of the power distribution wiring harness, wherein the electronic control system (25) is configured for:

obtaining, during a first detection event in which the first electrical load is in an inactive operating state, terminal voltage level of the DC voltage source (U_VS_Inactive) and voltage level of the first electrical load (U_L1_Inactive);

obtaining, during a second detection event in which the first electrical load is in an active operating state, terminal voltage level of the DC voltage source (U_VS_Active), the voltage level of the first electrical load (U_L1_Active) and an electrical current level (I_L1_Active) of the first electrical load (L1); and

calculating the resistance value of the section of the power distribution wiring harness that is connecting the DC voltage source with the first electrical load (L1) based on the obtained:

terminal voltage level of the DC voltage source in the inactive operating state (U_VS_Inactive);
voltage level of the first electrical load in the inactive operating state (U_L1_Inactive);
terminal voltage level of the DC voltage source in the active operating state (U_VS_Active);
voltage level of the first electrical load in the active operating state (U_L1_Active); and
electrical current level of the first electrical load (L1) in the active operating state (I_L1_Active).

13. The electrical system according to claim 12, wherein the resistance value (R_Wire_L1) of the section (S) of the power distribution wiring harness (2) that is connecting the DC voltage source (1) with the first electrical load (L1) is calculated based on the following equation:

$$R_{Wire\_L1} = \frac{\left(U_{L1\_Inactive} - U_{L1\_Active}\right) - \left(U_{VS\_Inactive} - U_{VS\_Active}\right)}{I_{L1\_Active}}.$$

14. The electrical system according to any of the previous claims 12 to 13, wherein the electronic control system (25) configured for:

comparing the calculated resistance value (R_Wire_L1) of the section (S) of the power distribution wiring harness (2), or a voltage drop based on said resistance value (R_Wire_L1), with a threshold value; and
activating a vehicle load reducing control strategy and/or informing a vehicle user and/or a remote vehicle service manager about a power supply concern in response to determining that the calculated resistance value (R_Wire_L1) of the section (S) of the power distribution wiring harness (2), or the voltage drop based on said resistance value (R_Wire_L1), is larger than the threshold value.

15. A vehicle comprising the electrical system according to any of the previous claims 12 to 14.

FIG.1

FIG.2

FIG.3

FIG.4

FIG.5

FIG.6A

FIG.6B

FIG.7A

FIG.7B

R1=3mΩ
$I_{R1}$=5A
$U_{R1}$=0.015V

$I_{R2}$=5A

U_VS=11.975V

Ir=5mΩ
I_VS=5A
U_Ir=0.025V
U_EMF=12V

$U_{L1}$=11.96V

$I_{L2}$=5A

FIG.8A

R1=3mΩ
$I_{R1}$=10A
$U_{R1}$=0.03V

$I_{R2}$=5A

U_VS=11.95V

Ir=5mΩ
I_VS=10A
U_Ir=0.05V
U_EMF=12V

$U_{L1}$=11.92V
$I_{L1}$=5A

$I_{L2}$=5A

FIG.8B

FIG.9A

FIG.9B

FIG.10A

FIG.10B

FIG.11A

FIG.11B

## EUROPEAN SEARCH REPORT

**Application Number**

EP 24 18 5068

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | DE 10 2014 018640 B3 (AUDI AG [DE]) 3 March 2016 (2016-03-03) * figures * * claims * * paragraphs [0009] - [0045] * | 1-15 | INV. G01R27/08 |
| A | US 2014/118014 A1 (ORR RAYMOND KENNETH [CA] ET AL) 1 May 2014 (2014-05-01) * figures * * claims * * paragraphs [0050] - [0154] * | 1-15 | |
| A | CN 102 460 191 A (AC PROPULSION INC) 16 May 2012 (2012-05-16) * figures * * claims * * the whole document * | 1-15 | |

TECHNICAL FIELDS SEARCHED (IPC)

G01R

The present search report has been drawn up for all claims

| Place of search | Date of completion of the search | Examiner |
|---|---|---|
| The Hague | 19 November 2024 | Moulara, Guilhem |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

                                                             

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 24 18 5068

This annex lists the patent family members relating to the patent documents cited in the above-mentioned European search report.
The members are as contained in the European Patent Office EDP file on
The European Patent Office is in no way liable for these particulars which are merely given for the purpose of information.

19-11-2024

| Patent document cited in search report | Publication date | Patent family member(s) | | Publication date |
|---|---|---|---|---|
| DE 102014018640 B3 | 03-03-2016 | NONE | | |
| US 2014118014 A1 | 01-05-2014 | EP | 2725372 A1 | 30-04-2014 |
| | | US | 2014118014 A1 | 01-05-2014 |
| CN 102460191 A | 16-05-2012 | CN | 102460191 A | 16-05-2012 |
| | | US | 2010265051 A1 | 21-10-2010 |
| | | WO | 2010121075 A2 | 21-10-2010 |

For more details about this annex : see Official Journal of the European Patent Office, No. 12/82